(19) Europäisches Patentamt / European Patent Office / Office européen des brevets

(11) **EP 3 798 331 A1**

(12) **EUROPEAN PATENT APPLICATION**
published in accordance with Art. 153(4) EPC

(43) Date of publication:
**31.03.2021 Bulletin 2021/13**

(51) Int Cl.:
*C23C 14/56* (2006.01)    *F16C 13/00* (2006.01)

(21) Application number: **19807002.1**

(22) Date of filing: **24.01.2019**

(86) International application number:
**PCT/JP2019/002301**

(87) International publication number:
**WO 2019/225057 (28.11.2019 Gazette 2019/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.05.2018 JP 2018098645**

(71) Applicant: **SUMITOMO METAL MINING CO., LTD.**
**Tokyo**
**105-8716 (JP)**

(72) Inventor: **OKAMI, Hideharu**
**Niihama-shi, Ehime 792-0008 (JP)**

(74) Representative: **TBK**
**Bavariaring 4-6**
**80336 München (DE)**

(54) **GAS DISCHARGE ROLL, MANUFACTURING METHOD FOR SAME, AND PROCESSING DEVICE USING GAS DISCHARGE ROLL**

(57)    Provided is a gas discharge roll, which includes: an inner roll, which has a rotary shaft; an outer roll, which is fitted and integrated with an outer peripheral surface of the inner roll; gas introduction grooves, which are formed on the outer peripheral surface of the inner roll over an entire circumference thereof at substantially uniform intervals along a circumferential direction of the inner roll so as to extend along a rotary shaft direction of the inner roll, and which are configured to define gas introduction channels between an inner peripheral surface of the outer roll and the gas introduction grooves; and a group of gas discharge holes formed on the outer roll so as to penetrate through to the gas introduction channels. A circumferential cutoff rate of a gas introduction channel cross-section is 36% or less, or a porosity within a gas introduction range is 20% or less.

FIG.1A

1 GAS DISCHARGE ROLL
12 CONVEYANCE UNIT
11 LONG RESIN FILM
13 SURFACE TREATMENT UNIT

## FIG.1B

3 OUTER ROLL

5 GAS INTRODUCTION
CHANNEL

4 GAS INTRODUCTION
GROOVE

2 INNER ROLL

1

6 GAS DISCHARGE
HOLE

6

8 COOLANT CIRCULATION
CHANNEL

7 COOLANT PARTITION
MEMBER

## FIG.1C

5   6        A        6     3

2        B      4     r2   r1

**Description**

BACKGROUND OF THE INVENTION

Field of the Invention

The present invention relates to a gas discharge roll which includes a plurality of gas introduction channels each extending in an axial direction in the vicinity of an outer peripheral surface, and which is capable of discharging a gas to the entire outer peripheral surface, and more particularly, to a gas discharge roll of a type in which an outer roll, which is made of metal with a cylindrical shape, is fitted and fixed to an outer peripheral surface of an inner roll made of metal and a manufacturing method for the same, and a processing apparatus using a gas discharge roll.

Description of the Related Art

In a liquid crystal panel, a notebook computer, a digital camera, a mobile phone, and the like, a flexible wiring board having a heat-resistant resin film covered with a metal film is used. In the flexible wiring board, a heat-resistant resin film with a metal film, in which the metal film is formed on one surface or both surfaces of the heat-resistant resin film, is used. Along with the recent increase in fineness and density of a wiring pattern, it is considered to be important that the heat-resistant resin film with a metal film itself is smooth without having wrinkles and the like.

As a method of manufacturing a long heat-resistant resin film with a metal film of this kind, there have hitherto been known a manufacturing method involving bonding a metal foil to a heat-resistant resin film with an adhesive (manufacturing method for a three-layer substrate), a manufacturing method involving applying a heat-resistant resin solution to a metal foil, followed by drying (casting method), a manufacturing method involving forming a metal film on a heat-resistant resin film by a vacuum deposition method or by a vacuum deposition method and a wet plating method (metallizing method), and the like. In addition, as the vacuum deposition method to be used in the metallizing method, there are given a vacuum vapor deposition method, a sputtering method, an ion plating method, an ion beam sputtering method, and the like.

Regarding the metallizing method, in Japanese Patent Application Laid-open No. Hei 2-098994, there is described a method involving sputtering a chromium layer onto a polyimide insulating layer, followed by sputtering copper, to thereby form a conductor layer on the polyimide insulating layer. In addition, in Japanese Patent No. 3447070, there is disclosed a material for a flexible circuit board obtained by laminating, on a polyimide film, a first metal thin film formed by sputtering with use of a copper-nickel alloy as a target and a second metal thin film formed by sputtering with use of copper as a target in the stated order. When vacuum deposition is performed on a heat-resistant resin film, such as a polyimide film, a sputtering web coater is generally used.

Incidentally, it is said that, in the above-mentioned vacuum deposition method, the sputtering method is generally excellent in adhesion force, but the thermal load thereof to be given to the heat-resistant resin film is larger than that in the vacuum vapor deposition method. It is also known that, when a large thermal load is applied to the heat-resistant resin film during deposition, wrinkles are liable to occur in the film. In order to prevent the occurrence of the wrinkles, in the sputtering web coater that is an apparatus for manufacturing a heat-resistant resin film with a metal film, there is adopted a method involving cooling the heat-resistant resin film during deposition from a back surface side by winding the heat-resistant resin film that is being conveyed around a can roll through use of a roll-to-roll system.

For example, in Japanese Patent Application Laid-open No. 62-247073, there is disclosed a vacuum sputtering apparatus using a rewinding/winding system (roll-to-roll system), which is one example of the sputtering web coater. The vacuum sputtering apparatus of a rewinding/winding system includes a cooling roll configured to serve as a can roll, and is further configured to perform control of bringing a heat-resistant resin film into contact with the cooling roll through use of a sub-roll provided at least on a film feeding side or a film delivery side of the cooling roll.

However, as described in "Vacuum Heat Transfer Models for Web Substrates: Review of Theory and Experimental Heat Transfer Data," 2000 Society of Vacuum Coaters, 43rd. Annual Technical Conference Proceedings-Denver, April 15-20, 2000, p.335, the outer peripheral surface of the can roll is not flat when viewed microscopically, and hence a gap (gap portion) separated through intermediation of a vacuum space is present between the can roll and the heat-resistant resin film that is being conveyed in contact with the outer peripheral surface of the can roll. Therefore, it cannot be said that the heat of the heat-resistant resin film generated during deposition is efficiently transmitted to the can roll, and this causes the occurrence of the wrinkles of the film. According to "Improvement of Web Heat Condition by the Deposition Drum Design," 2007 Society of Vacuum Coaters, 50th. Annual Technical Conference Proceedings (2007), p.749, when an introduced gas is an argon gas, and the pressure of the introduced gas is 500 Pa, in a molecular flow region in which the distance of the gap portion between the outer peripheral surface of the can roll and the heat-resistant resin film is about 40 $\mu$m or less (including contact), the thermal conductance of the gap portion is 250 (W/m$^2$·K).

In order to solve the above-mentioned problem, a gas discharge can roll configured to introduce a gas from the can roll side into the gap portion between the outer peripheral surface of the can roll and the heat-resistant resin film has been proposed as a technology for setting the thermal conductivity of the gap portion to be higher than that in a vacuum. For example, in International Patent WO-2005/001157, as a method of introducing a gas from the can roll side, there is disclosed a technology for forming a large number of minute holes serving as gas introduction ports on the outer peripheral surface of the can roll.

As described above, it is required that the can roll configured to subject the film to the deposition process in vacuum as in the sputtering web coater include a cooling mechanism.

Such a cooling can roll includes an outer pipe serving as an outer roll and an inner drum serving as an inner roll. In the cooling can roll, there has hitherto been adopted a method called shrink fitting involving warming and thermally expanding the outer pipe with respect to the inner drum that is slightly smaller than the outer pipe and fitting the outer pipe with the inner drum. Further, a large thermal load may be applied to the outer pipe during use. A large thermal load may be applied to the outer pipe when the outer pipe is processed. In addition, the fastening stress may be reduced when the outer pipe is cut to be thin. The inner drum and the outer pipe may be loosened when high-temperature heat treatment is performed. Therefore, in each of Japanese Patent No. 5920199 and Japanese Patent No. 5970422, there is described a procedure for welding grooves by laser welding or with an electron beam.

The grooves are referred to as "gas introduction channels" after the inner drum and the outer pipe are shrink-fitted with each other. Holes that penetrate through to the gas introduction channels and the can roll surface are gas discharge holes. It can be easily assumed to be appropriate that the gas discharge holes be thin so as not to hinder the thermal conduction of the can roll surface, and the number of the gas discharge holes be larger in order to obtain a uniform gas distribution. However, in order to increase the number of the gas discharge holes, the number of the gas introduction channels are also required to be increased. It is not preferred that the number of the gas introduction channels be increased because a large number of gas introduction channels may serve as heat insulating regions that hinder the thermal transmission of cooling water and the can roll surface. In view of the foregoing, in Japanese Patent No. 5673610, there has been proposed a technology for forming the gas discharge holes, which are opposed to one gas introduction channel from a diagonal direction, with a laser. In this case, 180 gas introduction channels are formed at angular intervals of 2°, and the gas discharge holes each having a diameter of 0.2 mm penetrate through to one gas introduction channel diagonally from both sides. In this related art, each of the gas introduction channels is opened with a gun drill, and hence the cross-section of the gas introduction channel is limited to a circular shape. However, the cross-section of the gas introduction channel to be formed by combination of the gas groove and shrink fitting depends on the shape of a grooving cutter, and hence the cross-section may also be set to a square shape, a U-shape, or a triangular shape.

CONVENTIONAL ART DOCUMENTS

PATENT DOCUMENTS

PATENT DOCUMENT 1: Japanese Patent Application Publication No. Hei 2-098994
Patent Document 2: Japanese Patent No. 3447070
Patent Document 3: Japanese Patent Application Publication No. Sho 62-247073
Patent Document 4: International Publication No. WO2005/001157
Patent Document 5: Japanese Patent No. 5920199
Patent Document 6: Japanese Patent No. 5970422
Patent Document 7: Japanese Patent No. 5673610

NON-PATENT DOCUMENTS

Non-Patent Document 1: "Vacuum Heat Transfer Models for Web Substrates: Review of Theory and Experimental Heat Transfer Data", 2000 Society of Vacuum Coaters, 43rd Annual Technical Conference Proceeding, Denver, April 15-20, 2000, p.335
Non-Patent Document 2: "Improvement of Web Condition by the Deposition Drum Design", 2000 Society of Vacuum Coaters, 50th Annual Technical Conference Proceeding (2007), p.749

SUMMARY OF THE INVENTION

PROBLEM TO BE SOLVED BY THE INVENTION

As described above, it can be easily assumed to be appropriate that the gas discharge holes of the cooling can roll configured to subject the film to the deposition process in vacuum as in the sputtering web coater be thin so as not to hinder the thermal conduction of the can roll surface, and the number of the gas discharge holes be larger in order to obtain a uniform gas distribution. However, in order to increase the number of the gas discharge holes, the number of the gas introduction channels are also required to be increased. It is not preferred that the number of the gas introduction channels be increased because a large number of gas introduction channels may serve as heat insulating regions that hinder the thermal transmission of cooling water and the can roll surface.

In particular, when each of the gas introduction channels is formed with a gun drill, the cross-section of the gas introduction channel is limited to a circular shape. However, the cross-section of the gas introduction channel to be formed by combination of the gas groove and shrink fitting depends on the shape of a cutting edge of a grooving cutter. Therefore, although it is difficult to set the cross-section to a circular shape in this case, the cross-section can also be set to a U-shape, a square shape, or a triangular shape. In addition, a thin groove that cannot be achieved with the gun drill can also be formed.

Further, as disclosed in Japanese Patent No. 5673610, when the gas discharge holes that are opposed to one gas introduction channel from a diagonal direction are formed with a laser, it is also possible to form the gas discharge holes by the number twice that of the gas introduction channels.

In addition, it is apparent that, when thin and shallow grooves are formed, the heat insulating regions that hinder the thermal transmission of cooling water and the can roll surface are reduced as compared to the case in which thick and deep grooves are formed with the grooving cutter. However, there arise problems in terms of manufacturing of the cooling can roll. It is difficult to match the position of each of the gas discharge holes formed with a laser with a thin groove. Further, sputter and dross excessively come close to an opening portion and a groove bottom during penetration in which the gas discharge hole is formed with a laser in a shallow groove, with the result that the opening portion may be closed.

In view of the foregoing, the inventor of the present invention has investigated optimum ranges as to the shape of each of grooves to be formed on the inner drum with the grooving cutter and the intervals therebetween, to thereby achieve the present invention.

A technical object to be achieved by the present invention is to provide a gas discharge roll in which a plurality of gas introduction channels each extending in an axial direction can be formed in the vicinity of an outer peripheral surface over an entire circumference without using gun drilling, and cooling performance with respect to a thermal load can be satisfactorily kept.

MEANS FOR SOLVING THE PROBLEM

According to a first technical feature of the present invention, there is provided a gas discharge roll, including:

an inner roll, which is made of metal, and has a rotary shaft in an end portion;
an outer roll, which is made of metal with a cylindrical shape, and is fitted and integrated with an outer peripheral surface of the inner roll;
gas introduction grooves, which are formed on the outer peripheral surface of the inner roll over an entire circumference thereof at substantially uniform intervals along a circumferential direction of the inner roll so as to extend along a rotary shaft direction of the inner roll, and which define gas introduction channels between an inner peripheral surface of the outer roll and the gas introduction grooves; and
a group of gas discharge holes formed on the outer roll so as to penetrate through to the gas introduction channels, the gas discharge roll has a circumferential cutoff rate A of a gas introduction channel cross-section of 36% or less, where the circumferential cutoff rate A of a gas introduction channel cross-section = (maximum width in the circumferential direction of the gas introduction channel cross-section × number of gas introduction channels)/(minimum diameter circumference length cutting across a maximum width position in the circumferential direction of the gas introduction channel cross-section).

According to a second technical feature of the present invention, there is provided a gas discharge roll, including:

an inner roll, which is made of metal, and has a rotary shaft in an end portion;
an outer roll, which is made of metal with a cylindrical shape, and is fitted and integrated with an outer peripheral surface of the inner roll;

gas introduction grooves, which are formed on the outer peripheral surface of the inner roll over an entire circumference thereof at substantially uniform intervals along a circumferential direction of the inner roll so as to extend along a rotary shaft direction of the inner roll, and which define gas introduction channels between an inner peripheral surface of the outer roll and the gas introduction grooves; and

a group of gas discharge holes formed on the outer roll so as to penetrate through to the gas introduction channels, the gas discharge roll has a porosity B within a gas introduction range of 20% or less,

where the porosity B within a gas introduction range = (sectional area of the gas introduction channel × number of gas introduction channels)/(annular area surrounded by a maximum diameter circumference and a minimum diameter circumference sandwiching the gas introduction channel cross-section).

According to a third technical feature of the present invention, in the gas discharge roll having the first or the second technical feature, the group of gas discharge holes have arrangement intervals along the circumferential direction of the gas discharge roll, which are smaller than arrangement intervals of the gas introduction channels.

According to a fourth technical feature of the present invention, in the gas discharge roll having the first or the second technical feature, the gas introduction grooves each have a non-circular cross-section.

According to a fifth technical feature of the present invention, in the gas discharge roll having the first or the second technical feature, the group of gas discharge holes are each arranged so as to be inclined with respect to a radial direction of the outer roll.

According to a sixth technical feature of the present invention, there is provided a method of manufacturing a gas discharge roll, the gas discharge roll including an inner roll, which is made of metal and has a rotary shaft in an end portion, and an outer roll, which is made of metal with a cylindrical shape and has an inner peripheral surface that is brought into contact with an outer peripheral surface of the inner roll, the gas discharge roll enabling a gas to be discharged to a surface of the outer roll,

the method including:

a groove forming step of forming a plurality of gas introduction grooves each extending in a rotary shaft direction on the outer peripheral surface of the inner roll over an entire circumference thereof at substantially uniform intervals;

a shrink fitting step of shrink-fitting the outer roll with the outer peripheral surface of the inner roll having the plurality of gas introduction grooves formed thereon in the groove forming step;

a joining step of joining the inner roll and the outer roll, which have been shrink-fitted with each other, by welding; and

a hole forming step of forming a group of gas discharge holes on the outer roll, the group of gas discharge holes respectively penetrating through to a plurality of gas introduction channels defined between the plurality of gas introduction grooves formed on the outer peripheral surface of the inner roll and the inner peripheral surface of the outer roll,

the groove forming step is performed so that the gas discharge roll has a circumferential cutoff rate A of a gas introduction channel cross-section of 36% or less,

where the circumferential cutoff rate A of a gas introduction channel cross-section = (maximum width in the circumferential direction of the gas introduction channel cross-section × number of gas introduction channels)/(minimum diameter circumference length cutting across a maximum width position in the circumferential direction of the gas introduction channel cross-section).

According to a seventh technical feature of the present invention, there is provided a method of manufacturing a gas discharge roll, the gas discharge roll including an inner roll, which is made of metal and has a rotary shaft in an end portion, and an outer roll, which is made of metal with a cylindrical shape and has an inner peripheral surface that is brought into contact with an outer peripheral surface of the inner roll, the gas discharge roll enabling a gas to be discharged to a surface of the outer roll,
the method including:

a groove forming step of forming a plurality of gas introduction grooves each extending in a rotary shaft direction on the outer peripheral surface of the inner roll over an entire circumference thereof at substantially uniform intervals;
a shrink fitting step of shrink-fitting the outer roll with the outer peripheral surface of the inner roll having the plurality of gas introduction grooves formed thereon in the groove forming step;
a joining step of joining the inner roll and the outer roll, which have been shrink-fitted with each other, by welding; and
a hole forming step of forming a group of gas discharge holes on the outer roll, the group of gas discharge holes respectively penetrating through to a plurality of gas introduction channels defined between the plurality of gas introduction grooves formed on the outer peripheral surface of the inner roll and the inner peripheral surface of the outer roll,
the groove forming step is performed so that the gas discharge roll has a porosity B within a gas introduction range of 20% or less,

where the porosity B within a gas introduction range = (sectional area of the gas introduction channel × number of gas introduction channels)/(annular area surrounded by a maximum diameter circumference and a minimum diameter circumference sandwiching the gas introduction channel cross-section).

According to an eighth technical feature of the present invention, there is provided a processing apparatus, including: the gas discharge roll having any one of the first to the fifth technical features; a conveyance unit conveyed a long resin film while winding the long resin film around the gas discharge roll; and a surface treatment unit, which is provided so as to be opposed to an outer peripheral surface of the gas discharge roll, and which performs surface treatment involving applying a thermal load onto the long resin film wound around the gas discharge roll.
According to the first or second technical feature of the present invention, there can be provided a gas discharge roll in which a plurality of gas introduction channels each extending in an axial direction can be formed in the vicinity of an outer peripheral surface over an entire circumference without using gun drilling, and cooling performance with respect to a thermal load can be satisfactorily kept.
According to the third technical feature of the present invention, even in a mode in which the arrangement intervals of the gas introduction channels along the circumferential direction of the gas discharge roll are increased, the gas discharge distribution from the group of gas discharge holes can be uniformly dispersed.

According to the fourth technical feature of the present invention, the gas introduction channels can be easily constructed by forming the gas introduction grooves with a grooving cutter without using gun drilling.

According to the fifth technical feature of the present invention, as compared to a mode in which the gas discharge holes are formed at the same intervals as the arrangement intervals of the gas introduction channels, the number of the gas discharge holes can be easily increased with respect to each of the gas introduction channels.

According to the sixth or seventh technical feature of the present invention, there can be provided a method of manufacturing a gas discharge roll in which a plurality of gas introduction channels each extending in an axial direction can be formed in the vicinity of an outer peripheral surface over an entire circumference without using gun drilling, and cooling performance with respect to a thermal load can be satisfactorily kept.

According to the eighth technical feature of the present invention, there can be provided a processing apparatus including a gas discharge roll in which a plurality of gas introduction channels each extending in an axial direction can be formed in the vicinity of an outer peripheral surface over an entire circumference without using gun drilling, and cooling performance with respect to a thermal load can be satisfactorily kept.


BRIEF DESCRIPTION OF THE DRAWINGS

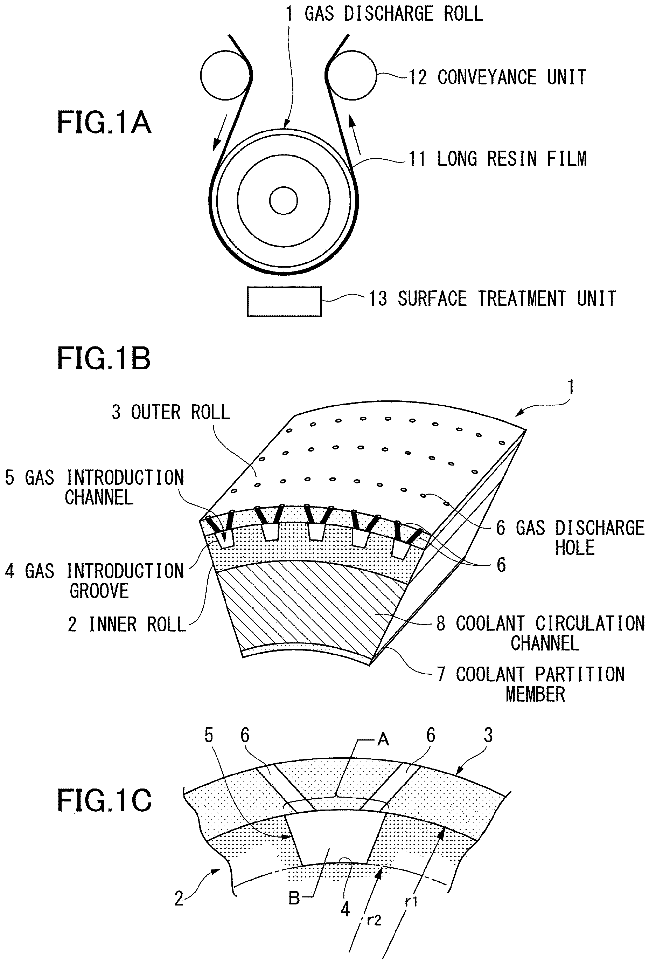

FIG. 1A is an explanatory view for illustrating an overview of an embodiment of a processing apparatus using a gas discharge roll to which the present invention is applied. FIG. 1B is an explanatory view for illustrating a configuration example of the gas discharge roll illustrated in FIG. 1A. FIG. 1C is an explanatory view for illustrating main parts on the periphery of a gas introduction channel of the gas discharge roll illustrated in FIG. 1A.

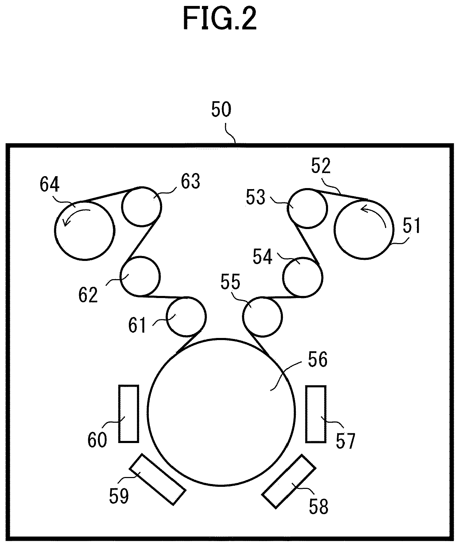

FIG. 2 is a schematic view for illustrating one example of a processing apparatus using a roll-to-roll system for a long resin film substrate according to a first embodiment of the present invention.

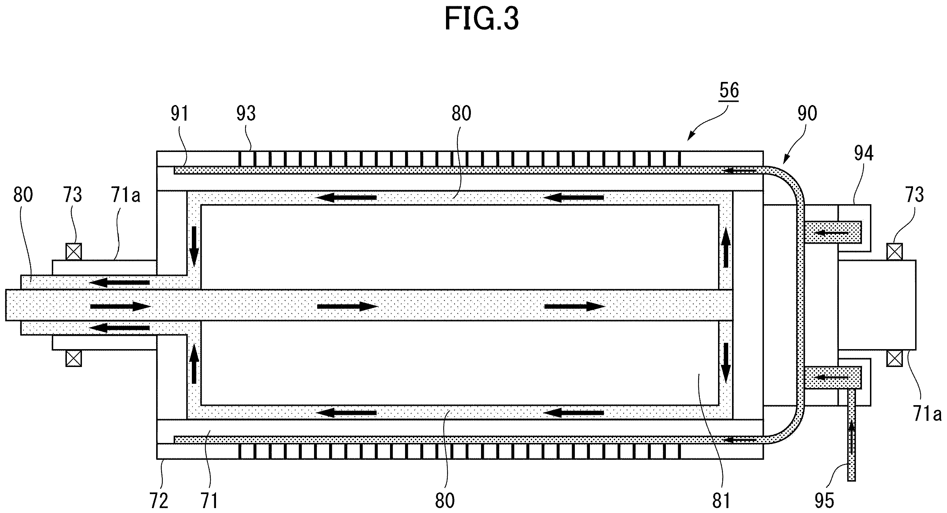

FIG. 3 is a schematic sectional view for illustrating one specific example of a gas introduction/discharge mechanism and a coolant circulation mechanism of a can roll used in the first embodiment.

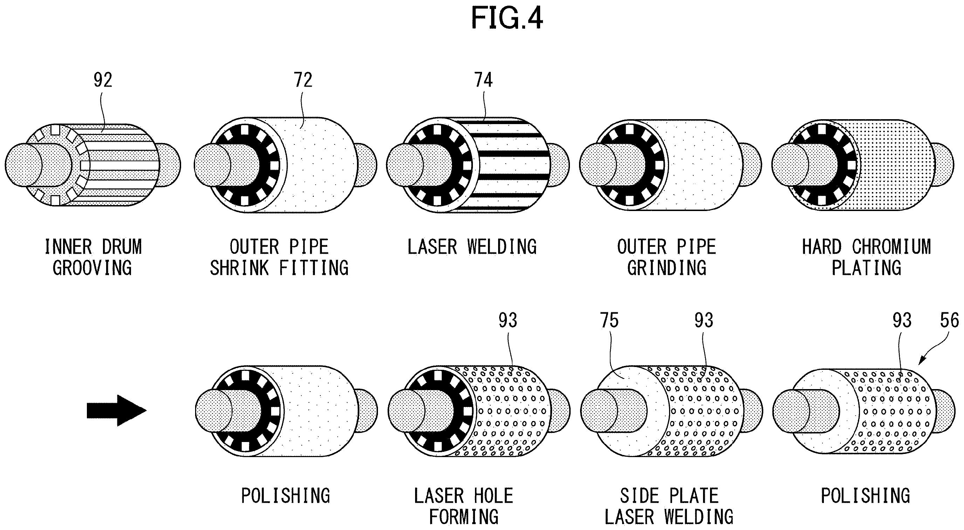

FIG. 4 is an explanatory view for illustrating one example of a manufacturing process of the can roll used in the first embodiment.

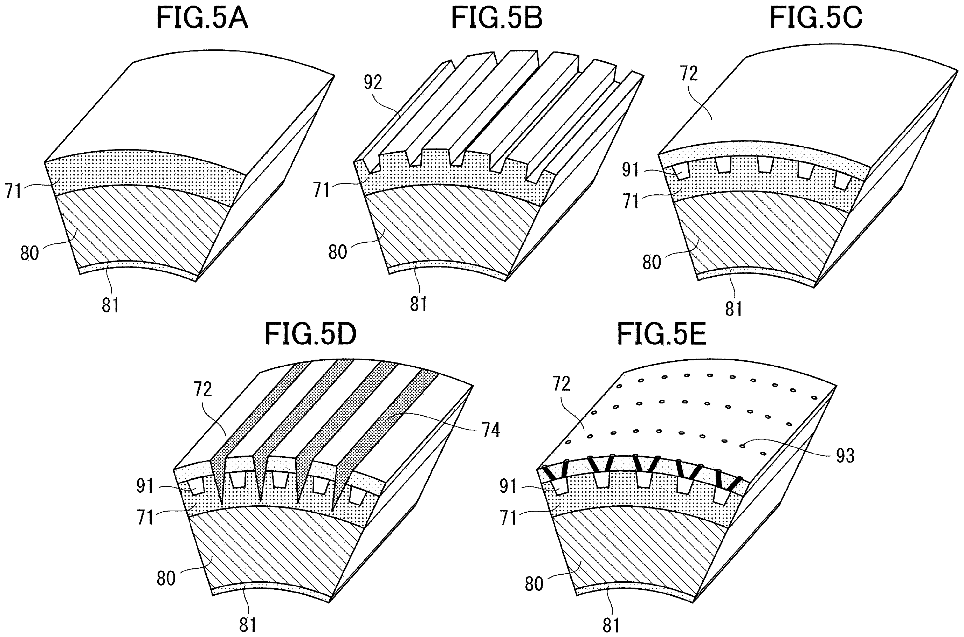

FIG. 5A, FIG. 5B, FIG. 5C, FIG. 5D, and FIG. 5E are each an explanatory partial sectional view for schematically illustrating a change in structure in association with the manufacturing process of the can roll used in the first embodiment.

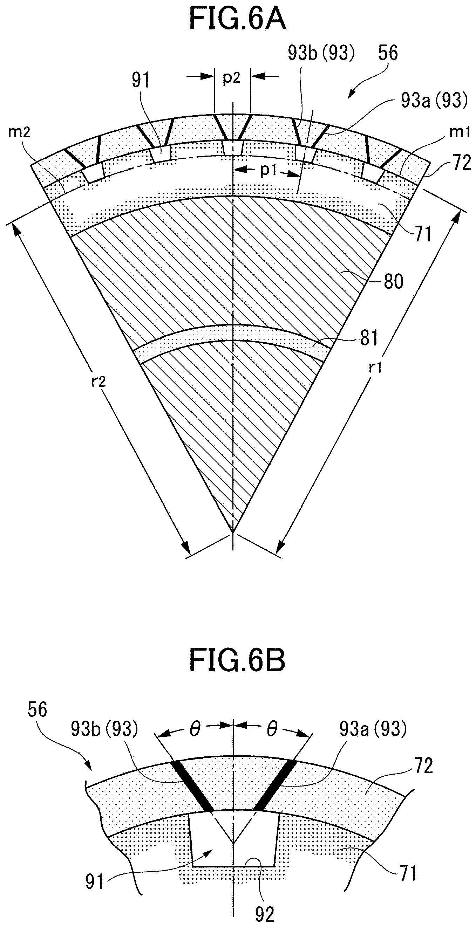

FIG. 6A is an explanatory view for illustrating arrangement pitches of gas introduction channels and gas discharge holes of the can roll according to the first embodiment. FIG. 6B is an explanatory view for illustrating an arrangement example of the gas discharge holes with respect to the gas introduction channel of the can roll according to the first embodiment.

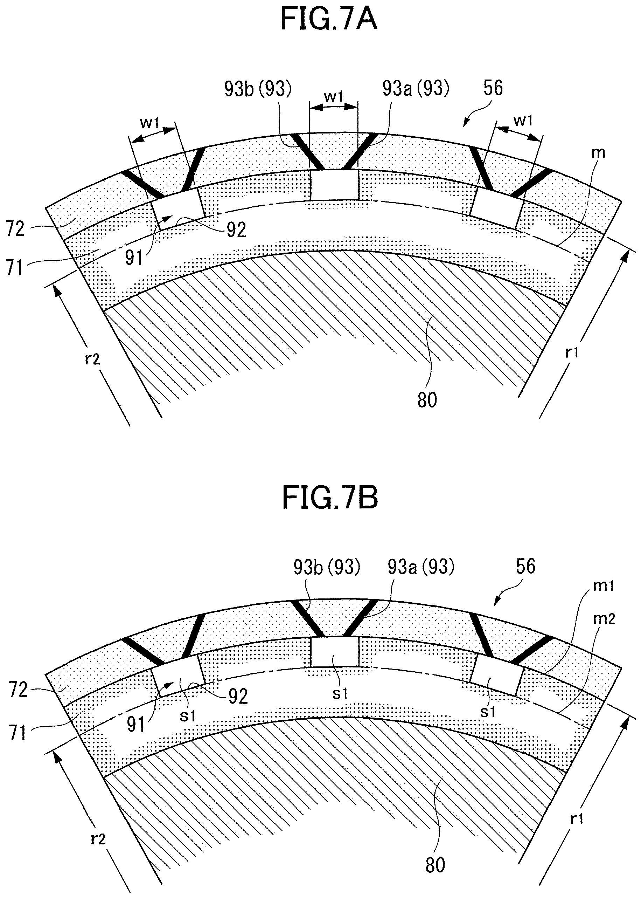

FIG. 7A is an explanatory view for illustrating a condition for a circumferential cutoff rate A of a gas introduction channel cross-section of the can roll according to the first embodiment. FIG. 7B is an explanatory view for illustrating a condition for a porosity B within a gas introduction range of the can roll according to the first embodiment.

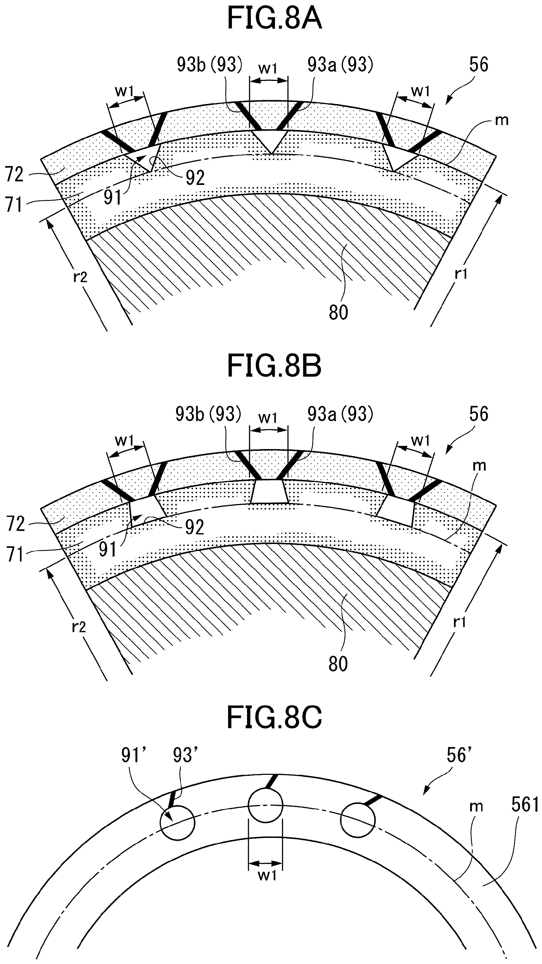

FIG. 8A is an explanatory view for illustrating a minimum diameter circumference m in a mode in which the cross-section of each of the gas introduction channels used in the first embodiment has a triangular shape. FIG. 8B is an explanatory view for illustrating a minimum diameter circumference m in a mode in which the cross-section of each of the gas introduction channels used in the first embodiment has a trapezoidal shape. FIG. 8C is an explanatory view for illustrating a minimum diameter circumference m in a mode in which the cross-section of each of gas introduction channels used in a first comparative embodiment has a circular shape.

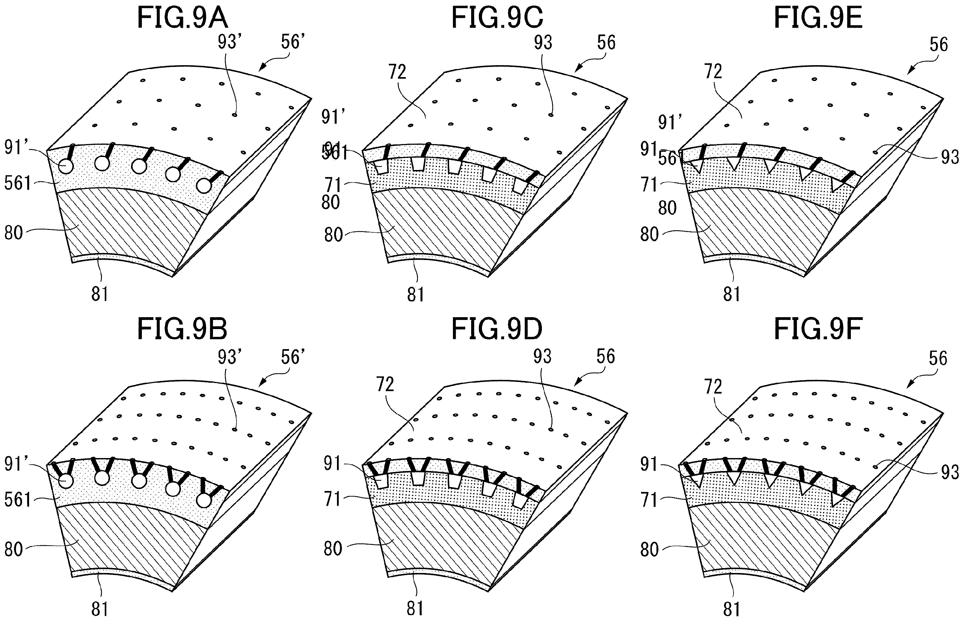

FIG. 9A and FIG. 9B are explanatory views for respectively illustrating main parts of can rolls according to Comparative Examples 1 and 2. FIG. 9C and FIG. 9D are explanatory views for respectively illustrating main parts of can rolls according to Examples 1 and 2. FIG. 9E and FIG. 9F are explanatory views for respectively illustrating main parts of can rolls according to Examples 3 and 4.

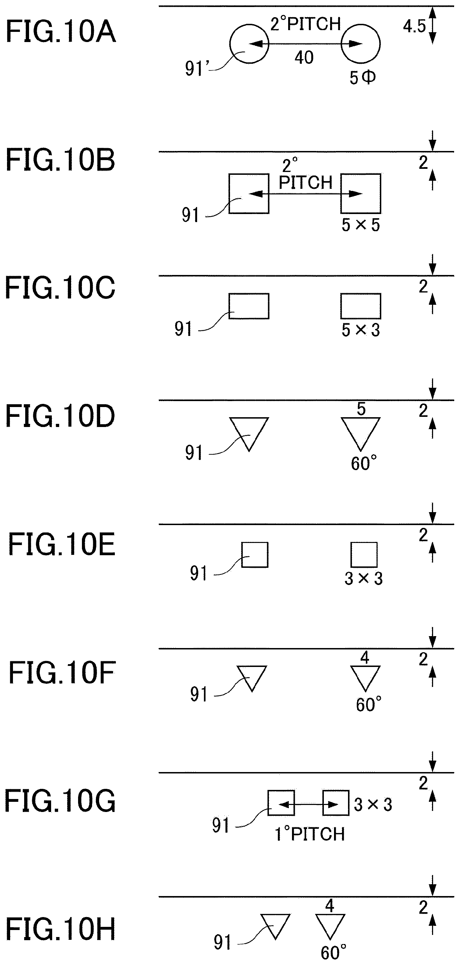

FIG. 10A is an explanatory view for illustrating Specific Example 1 of the can rolls according to Comparative Examples 1 and 2. FIG. 10B is an explanatory view for illustrating Specific Example 1 of the can rolls according to Examples 1 and 2. FIG. 10C is an explanatory view for illustrating Specific Example 2 of the can rolls according to Examples 1 and 2. FIG. 10D is an explanatory view for illustrating Specific Example 1 of the can rolls according to Examples 3 and 4. FIG. 10E is an explanatory view for illustrating Specific Example 3 of the can rolls according to Examples 1 and 2. FIG. 10F is an explanatory view for illustrating Specific Example 2 of the can rolls according to Examples 3 and 4. FIG. 10G is an explanatory view for illustrating Specific Example 4 of the can rolls according to Examples 1 and 2. FIG. 10H is an explanatory view for illustrating Specific Example 3 of the can rolls according to Examples 3 and 4.

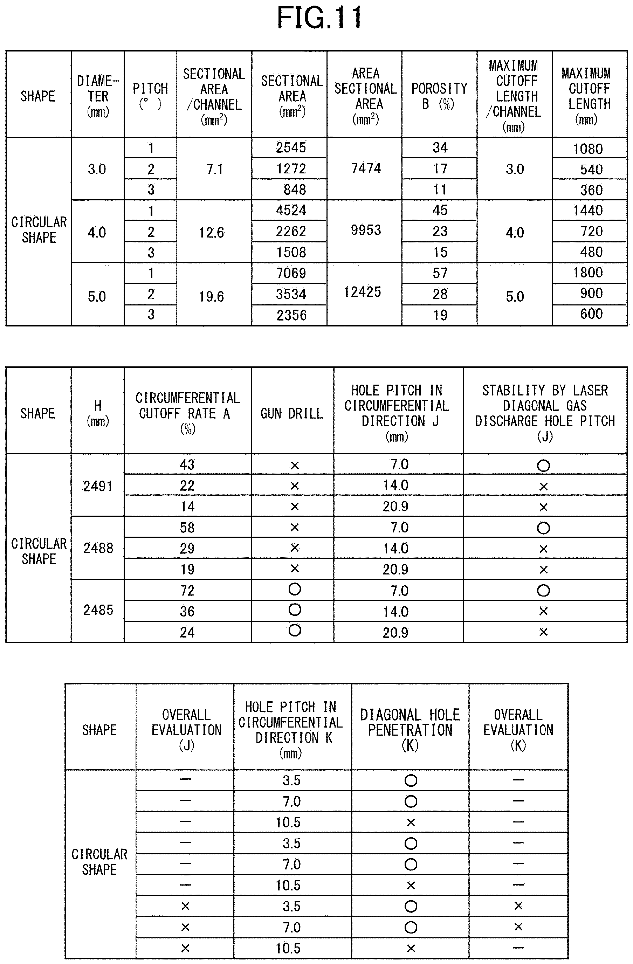

FIG. 11 is an explanatory table for showing evaluation of performance with respective changes in conditions for Comparative Examples 1 and 2 and Examples 1 to 4. In FIG. 11, reference symbol H represents "circumference of a maximum cutoff length position", reference symbol J represents "one gas discharge hole/gas introduction channel", and reference symbol K represents "two gas discharge holes/gas introduction channel".

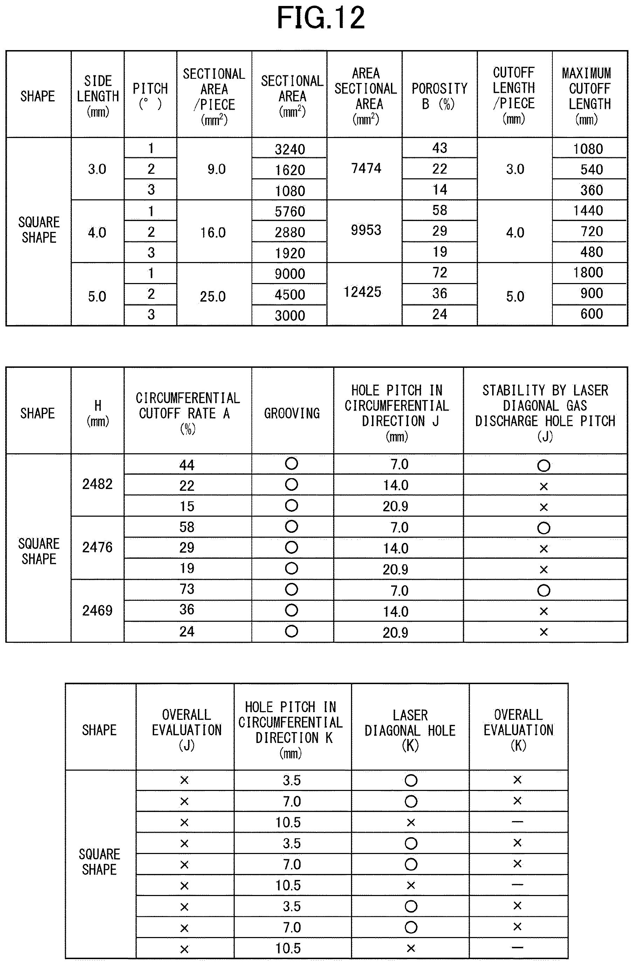

FIG. 12 is an explanatory table for showing evaluation of performance with respective changes in conditions for Comparative Examples 1 and 2 and Examples 1 to 4. In FIG. 12, reference symbol H represents "circumference of a maximum cutoff length position", reference symbol J represents "one gas discharge hole/gas introduction channel", and reference symbol K represents "two gas discharge holes/gas introduction channel".

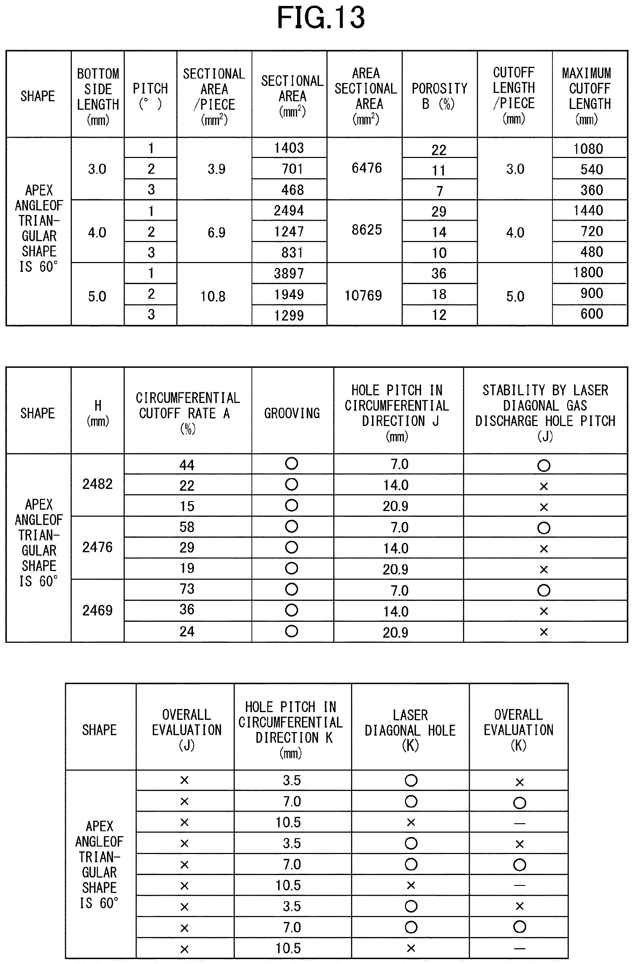

FIG. 13 is an explanatory table for showing evaluation of performance with respective changes in conditions for Comparative Examples 1 and 2 and Examples 1 to 4. In FIG. 13, reference symbol H represents "circumference of a maximum cutoff length position", reference symbol J represents "one gas discharge hole/gas introduction channel", and reference symbol K represents "two gas discharge holes/gas introduction channel".

DESCRIPTION OF THE EMBODIMENTS

Overview of Embodiment

FIG. 1A is an explanatory view for illustrating an overview of an embodiment of a processing apparatus using a gas discharge roll to which the present invention is applied.

In FIG. 1A, for example, the processing apparatus is configured to perform surface treatment, such as a deposition process, involving applying a thermal load onto a long resin film 11. The processing apparatus includes a gas discharge roll 1, a conveyance unit 12, and a surface treatment unit 13. The gas discharge roll 1 is capable of discharging a gas, which does not impair the thermal conduction, to a gap portion between the long resin film 11 and the gas discharge roll 1 while reducing the thermal load. The conveyance unit 12 is configured to convey the long resin film 11 while winding the long resin film 11 around the gas discharge roll 1. The surface treatment unit 13 is provided so as to be opposed to an outer peripheral surface of the gas discharge roll 1, and is configured to perform surface treatment involving applying a thermal load onto the long resin film 11 wound around the gas discharge roll 1.

In this case, the processing apparatus in this example is applied to a mode of conveying the long resin film 11 through use of a roll-to-roll system, and as the surface treatment unit 13, there are given a deposition unit, a plasma treatment unit, and an ion beam treatment unit.

In this example, as the gas discharge roll 1, there is given, as illustrated in FIG. 1B and FIG. 1C, a gas discharge roll including: an inner roll 2, which is made of metal, and has a rotary shaft in an end portion; an outer roll 3, which is made of metal with a cylindrical shape, and is fitted and integrated with an outer peripheral surface of the inner roll 2; gas introduction grooves 4, which are formed on the outer peripheral surface of the inner roll 2 over an entire circumference thereof at substantially uniform intervals along a circumferential direction of the inner roll 2 so as to extend along a rotary shaft direction of the inner roll 2, and which are configured to define gas introduction channels 5 between an inner peripheral surface of the outer roll 3 and the gas introduction grooves 4; and a group of gas discharge holes 6 formed on the outer roll 3 so as to penetrate through to the gas introduction channels 5. The gas discharge roll has a circumferential cutoff rate A of a gas introduction channel cross-section, which is defined as follows, of 36% or less.

The circumferential cutoff rate A of a gas introduction channel cross-section = (maximum width in the circumferential direction of the gas introduction channel cross-section × number of gas introduction channels)/(minimum diameter circumference length cutting across a maximum width position in the circumferential direction of the gas introduction channel cross-section)

In addition, as the gas discharge roll 1, there is given a gas discharge roll in which a porosity B within a gas introduction range, which is defined as follows, is 20% or less.

$$\text{The porosity B within a gas introduction range} = \text{(sectional area of the gas introduction channel} \times \text{number of gas introduction channels)} / \text{(annular area surrounded by a maximum diameter circumference } (2\pi r_1) \text{ and a minimum diameter circumference } (2\pi r_2) \text{ sandwiching the gas introduction channel cross-section)}$$

In FIG. 1B, there are illustrated a coolant partition member 7 incorporated into the inner roll 2, and a coolant circulation channel 8 formed between the coolant partition member 7 and the inner roll 2.

In such technical means, it is assumed that the gas discharge roll 1 has a configuration in which the cylindrical outer roll 3 is fitted and integrated with the outer peripheral surface of the inner roll 2. In this case, for example, shrink fitting is generally used as a fitting method. It is only required that the outer roll 3 be integrated with the inner roll 2, for example, by joining through welding after shrink fitting.

In addition, as the shape of the gas introduction groove 4, a rectangular shape (square shape), a triangular shape (V-shape), a U-shape, or the like may be appropriately selected as long as the shape can be formed on the outer peripheral surface of the inner roll 2 with a groove forming tool. The square shape also includes a trapezoidal shape in addition to a square and a rectangle.

Further, it is only required that the gas discharge holes 6 penetrate through to each of the gas introduction channels 5, and be formed in at least one row in a rotary shaft direction of the outer roll 3. In this case, in order to substantially uniformly distribute a gas discharged to the outer peripheral surface of the gas discharge roll 1, it is preferred that the group of gas discharge holes 6 be substantially uniformly arranged on the outer peripheral surface of the outer roll 3. In addition, the gas discharge holes 6 may be formed in a direction along a radial direction of the outer roll 3 or be formed so as to be arranged and inclined with respect to the radial direction of the outer roll 3

In this example, the requirement that the circumferential cutoff rate A of a gas introduction channel cross-section is 36% or less is based on evaluation results of Examples and Comparative Examples described later. In a mode in which the circumferential cutoff rate A of a gas introduction channel cross-section is more than 36%, the heat insulating action of the gas introduction channels 5 is strong, and the tendency that wrinkles and deformation are liable to occur in the long resin film 11 is observed.

In addition, the requirement that the porosity B within a gas introduction range is 20% or less is also based on the evaluation results of Examples and Comparative Examples described later. In a mode in which the porosity B within a gas introduction range is more than 20%, the heat insulating action of the gas introduction channels 5 is strong, and the tendency that wrinkles and deformation are liable to occur in the long resin film 11 is observed.

Even when the circumferential cutoff rate A of a gas introduction channel cross-section is 36% or less, in a mode in which the porosity B within a gas introduction range is more than 20%, the heat insulating action of the gas introduction channels 5 is strong, and hence it is preferred that the gas introduction channels 5 each having the porosity B within a gas introduction range of 20% or less be constructed.

Next, a typical mode or a preferred mode of the gas discharge roll according to this embodiment is described.

First, as a preferred mode of the group of gas discharge holes 6, there is given a mode in which the arrangement intervals of the group of gas discharge holes 6 along a circumferential direction of the gas discharge roll 1 are smaller than the arrangement intervals of the gas introduction channels 5. This example is a mode in which the group of gas discharge holes 6 are arranged without reducing the arrangement intervals of the gas introduction channels 5 while reducing the arrangement intervals of the group of gas discharge holes 6. In this case, it is only required to form the gas discharge holes 6 that penetrate through to one gas introduction channel 5 in a plurality of directions. In this example, in a mode of reducing the arrangement intervals of the gas introduction channels 5, the circumferential cutoff rate A of a gas introduction channel cross-section and the porosity B within a gas introduction range are liable to deviate from the upper limit conditions. Therefore, it is required to reduce the arrangement intervals of the group of gas discharge holes 6 without reducing the arrangement intervals of the gas introduction channels 5.

Further, as a preferred mode of the group of gas discharge holes 6, there is given a mode in which the group of gas discharge holes 6 are arranged so as to be inclined with respect to the radial direction of the outer roll 3. In this example, for example, when the gas discharge holes 6 are arranged so as to be inclined symmetrically with respect to the radial direction of the outer roll 3, the group of gas discharge holes 6 can be formed by the number twice that of the gas introduction channels 5 having predetermined arrangement intervals, with the result that the respective gas discharge holes 6 can be formed so as to have substantially the same length and size, and the gas discharge holes 6 along the circumferential direction of the gas discharge roll 1 can be arranged at substantially uniform arrangement intervals. However, it is not always required that, for example, all the gas discharge holes 6 be arranged so as to be inclined with respect to the radial direction of the outer roll 3. The gas discharge holes 6 along the radial direction of the outer roll 3 and the gas discharge holes 6 arranged so as to be inclined with respect to the radial direction of the outer roll 3 may be combined with each other. In this example, the gas discharge holes 6 along the circumferential direction of the gas discharge roll 1 can be arranged at substantially uniform arrangement intervals. However, the gas discharge holes 6 are liable to vary in length and size, and accordingly, the amount of a gas discharged from the gas discharge holes 6 may vary to some degree.

In addition, as a typical shape of the gas introduction groove 4, there is given a mode in which the gas introduction groove 4 has a non-circular cross-section. In this example, when the gas introduction groove 4 is formed by cutting with use of, for example, a grooving cutter as the groove forming tool, the shape of the gas introduction groove 4 depends on a cutting edge of the grooving cutter, and hence a U-shape, a rectangular shape, a triangular shape (V-shape), a trapezoidal shape, or the like can be selected as a sectional shape.

Next, a method of manufacturing the gas discharge roll 1 is described.

A method of manufacturing the gas discharge roll 1 in this example is performed as follows. In manufacturing of the gas discharge roll 1 including an inner roll 2, which is made of metal and has a rotary shaft in an end portion, and an outer roll 3, which is made of metal with a cylindrical shape and has an inner peripheral surface that is brought into contact with an outer peripheral surface of the inner roll 2, the gas discharge roll 1 being capable of discharging a gas to a surface of the outer roll 3, the method includes: a groove forming step of forming a plurality of gas introduction grooves 4 each extending in a rotary shaft direction on the outer peripheral surface of the inner roll 2 over an entire circumference thereof at substantially uniform intervals; a shrink fitting step of shrink-fitting the outer roll 3 with the outer peripheral surface of the inner roll 2 having the plurality of gas introduction grooves 4 formed thereon in the groove forming step; a joining step of joining the inner roll 2 and the outer roll 3, which have been shrink-fitted with each other, by welding; and a hole forming step of forming a group of gas discharge holes 6 on the outer roll 3, the group of gas discharge holes 6 respectively penetrating through to a plurality of gas introduction channels 5 defined between the plurality of gas introduction grooves 4 formed on the outer peripheral surface of the inner roll 2 and the inner peripheral surface of the outer roll 3. The groove forming step is performed so that the circumferential cutoff rate A of a gas introduction channel cross-section described above is 36% or less or the porosity B within a gas introduction range described above is 20% or less.

In such technical means, as welding in the joining step, there are given laser welding and electron beam welding. In this example, the inner roll 2 and the outer roll 3 are integrated with each other by welding after shrink fitting. Therefore, the fastening stress is not reduced when the outer roll 3 is cut to be thin. The inner roll 2 and the outer roll 3 are not loosened when high-temperature heat treatment is performed. Further, even in the case in which surface treatment involving applying a thermal load to the long resin film 11 on the gas discharge roll 1 is performed, loosening of the inner roll 2 and the outer roll 3 is expected to be suppressed when only the outer roll 3 reaches a high temperature or partially reaches a high temperature while the inner roll 2 is kept cooled.

In addition, in the hole forming step, a procedure for forming the gas discharge holes 6 with a laser is typically performed.

Now, the present invention is described in more detail by way of an embodiment illustrated in the attached drawings.

First Embodiment

-Overall Configuration of Deposition Apparatus-

As a processing apparatus using a roll-to-roll system for a long resin film substrate including a can roll, there is given, for example, a deposition apparatus illustrated in FIG. 2, specifically, a vacuum deposition apparatus using sputtering. The vacuum deposition apparatus using sputtering is specifically described with reference to FIG. 2. The deposition apparatus for a long resin film substrate illustrated in FIG. 2 is an apparatus called a sputtering web coater, and is suitably used in the case of subjecting the surface of a long resin film substrate conveyed through use of the roll-to-roll system to a deposition process continuously and efficiently.

A deposition apparatus (sputtering web coater) 50 for a long resin film substrate conveyed through use of the roll-to-roll system is configured to perform a predetermined deposition process while conveying a long resin film 52 unwound from an unwinding roll 51 under the condition of winding the long resin film 52 around a can roll 56 with a motor (not shown) and wind the resultant long resin film 52 around a winding roll 64. The can roll 56 arranged in the middle of a conveyance path extending from the winding roll 51 to the unwinding roll 64 is driven to rotate with the motor, and a coolant regulated for a temperature circulates in the can roll 56.

In sputtering deposition, the deposition apparatus 50 according to the first embodiment decompresses the inside of the deposition apparatus 50 to an ultimate pressure of from about 10 Pa to about 4 Pa, and then adjust the pressure of from about 0.1 Pa to about 10 Pa through introduction of a sputtering gas. As the sputtering gas, a known gas, such as argon, is used, and further, a gas, such as oxygen, is added depending on the purpose. There is no particular limitation on the shape and material for the deposition apparatus 50 as long as the deposition apparatus 50 can withstand a decompressed state, and various deposition apparatuses can be used. In order to maintain the decompressed state in the deposition apparatus 50, various devices (not shown), such as a dry pump, a turbo molecular pump, and a cryo coil, are provided in the deposition apparatus 50.

In a conveyance path extending from the unwinding roll 51 to the can roll 56, there are arranged a free roll 53 configured to guide the long resin film 52 and a tension sensor roll 54 configured to measure a tension of the long resin film 52. In addition, the long resin film 52, which is delivered from the tension sensor roll 54 and moves to the can roll 56, is adjusted to the peripheral speed of the can roll 56 by a motor-driven feed roll 55 provided in the vicinity of the can roll 56. With this, the long resin film 52 can be conveyed in contact with an outer peripheral surface of the can roll 56.

Also in a conveyance path extending from the can roll 56 to the winding roll 64, in the same manner as in the above, there are arranged a motor-driven feed roll 61, a tension sensor roll 62, and a free roll 63 in the stated order. The feed roll 61 is configured to perform adjustment to the peripheral speed of the can roll 56, the tension sensor roll 62 is configured to perform tension measurement of the long resin film 52, and the free roll 63 is configured to guide the long resin film 52.

In the unwinding roll 51 and the winding roll 64, the tension balance of the long resin film 52 is kept through torque control by a powder clutch or the like. In addition, due to the rotation of the can roll 56 and the motor-driven feed rolls 55 and 61 that are rotated in synchronization with the rotation of the can roll 56, the long resin film 52 is unwound from the unwinding roll 51 and wound around the winding roll 64.

In the vicinity of the can roll 56, magnetron sputtering cathodes 57, 58, 59, and 60 each serving as a deposition unit are provided at positions opposed to a conveyance path in which the long resin film 52 is wound around the outer peripheral surface of the can roll 56. An angle range in which the long resin film 52 is wound around the outer peripheral surface of the can roll 56 is sometimes referred to as "holding angle" of the long resin film 52.

In the case of sputtering deposition of a metal film, a plate-like target can be used as illustrated in FIG. 2. However, when the plate-like target is used, nodulation (growth of foreign matter) may occur on the target. When the nodulation causes a problem, it is preferred to use a cylindrical rotary target in which nodulation does not occur and the use efficiency of the target is also high.

In addition, in the deposition apparatus 50 for the long resin film 52 of FIG. 2, sputtering treatment is assumed as treatment involving applying a thermal load, and hence the magnetron sputtering cathodes 57, 58, 59, and 60 are illustrated. However, when the treatment involving applying a thermal load is another treatment, such as vapor deposition treatment, another vacuum deposition unit is provided instead of the plate-like target. As another vacuum deposition treatment involving applying a thermal load, chemical vapor deposition (CVD), vacuum vapor deposition, or the like can be used.

-Can Roll-

Next, a can roll used in the first embodiment is described with reference to FIG. 3.

In FIG. 3, the can roll 56 capable of discharging a gas is effective means from the viewpoint of discharging a gas from gas discharge holes formed on an outer peripheral surface, reducing a thermal load of a heat-resistant resin film serving as the long resin film 52 during deposition, and suppressing the occurrence of wrinkles.

In this case, the can roll 56 capable of discharging a gas includes a inner drum 71 (corresponding to an inner roll), which is made of metal, having a rotary shaft 71a in an end portion, and an outer pipe 72 (corresponding to an outer roll), which is made of metal with a cylindrical shape, that is fitted with an outer peripheral surface of the inner drum 71. A coolant circulation channel 80 is provided on an inner side of the inner drum 71 in order to cool the outer pipe 72, and a gas introduction/discharge mechanism 90 is provided in the can roll 56. In FIG. 3, there are illustrated bearings 73 configured to rotatably support the rotary shaft 71a of the inner drum 71.

In this example, a coolant circulation pipe 81 is built in the inner drum 71, and the coolant circulation channel 80 in which a coolant, such as cooling water, circulates is formed between the inner drum 71 and the coolant circulation pipe 81. In the coolant circulation channel 80, the coolant circulation pipe 81 may be wound in a helical fashion on an inner side of the inner drum 71. The coolant can circulate between a coolant cooling device (not shown) provided outside the apparatus and the coolant circulation channel 80. With this, the temperature of the outer pipe 72 of the can roll 56 can be regulated. Such a double pipe structure is called a jacket roll structure.

In addition, in this example, the gas introduction/discharge mechanism 90 has gas introduction channels 91 formed at predetermined arrangement intervals in a circumferential direction of the inner drum 71 between the inner drum 71 and the outer pipe 72. In the outer pipe 72, gas discharge holes 93 that penetrate through to each of the gas introduction channels 91 are formed. Meanwhile, a gas rotary joint 94 is incorporated into a portion close to one side of the rotary shaft 71a of the inner drum 71. Thus, an introduced gas is distributed from a gas introduction port 95 to the gas introduction channels 91. In particular, in this example, the gas rotary joint 94 is controlled by a gas supply control device (not shown), and as the gas supply control device, a device configured to close the gas introduction channels 91 with an electric or electromagnetic valve or the like configured to close a part of the gas rotary joint 94 is used. Therefore, the gas rotary joint 94 is configured to perform distribution of the introduced gas to the gas introduction channels 91 that require the introduced gas and suspension of distribution of the introduced gas to the gas introduction channels 91 that do not require the introduced gas. The gas introduction is performed only in the angle range (holding angle) of the can roll 56 wrapped with the long resin film 52. In this case, when the gas rotary joint 94 is not adopted, a large amount of a gas is discharged from portions of an outer surface of the can roll 56, which are not wrapped with the long resin film 52 and hence have less gas discharge resistance, with the result that the gas discharge amount from portions wrapped with the long resin film 52 to which a sputtering thermal load is applied is extremely decreased.

As described above, in this example, the gas introduced from the gas introduction port 95 is distributed to the gas introduction channels 91 that require the gas introduction through the gas rotary joint 94 and is discharged from the gas discharge holes 93 to a region between the outer surface of the can roll 56 and the long resin film 52.

-Manufacturing Process of Can Roll-

Next, an overview of the manufacturing process of the can roll 56 used in the first embodiment is described with reference to FIG. 4.

In FIG. 4, when the can roll 56 is manufactured, first, the outer peripheral surface of the inner drum 71 is subjected to grooving for gas introduction grooves 92 that function as the gas introduction channels 91, and the heated outer pipe 72 is shrink-fitted with the inner drum 71. Then, the gas introduction grooves 92 are subjected to welding 74 (laser welding or electron beam welding) so that the inner drum 71 and the outer pipe 72 are not loosened due to a difference in temperature. The welding 74 is not required to be performed between all the gas introduction grooves 92. After that, the outer pipe 72 is ground, and then subjected to hard chromium plating. The resultant is subjected to mirror polishing, and the gas discharge holes 93 are formed with a micro drill or a laser drill. After that, side plates 75 are laser-welded to both ends of the inner drum 71 and the outer pipe 72, and then final mirror polishing is performed to complete manufacturing of the can roll 56.

Now, the manufacturing process of the can roll 56 is described more specifically with reference to FIG. 5A to FIG. 5E.

First, as illustrated in a partial sectional view of FIG. 5A, the coolant circulation channel 80 is formed by the inner drum 71 and the coolant circulation pipe 81. Then, as illustrated in a partial sectional view of FIG. 5B, the gas introduction grooves 92 are formed by grooving on the inner drum 71 subjected to cylindrical grinding. In this example, the gas introduction grooves 92 each having, for example, a rectangular shape (square shape) in cross-section are formed.

Then, as illustrated in a partial sectional view of FIG. 5C, the thick outer pipe 72 is heated to be shrink-fitted with the inner drum 71. Further, as in a partial sectional view of FIG. 5D, an outer peripheral surface of the inner drum 71 other than the gas introduction grooves 92 and an inner peripheral surface of the outer pipe 72 are welded to each other by laser welding or electron beam welding, to thereby define the gas introduction channels 91 between the gas introduction grooves 92 of the inner drum 71 and the inner peripheral surface of the outer pipe 72. Finally, as illustrated in a partial sectional view of FIG. 5E, the gas discharge holes 93 are formed on the outer pipe 72 toward the gas introduction channels 91 with a micro drill or a laser drill. For example, after processing of the gas discharge holes 93 with the laser drill, a metal that is generated and melted during processing may adhere to the outer surface of the can roll 56, and the surface thereof is not flat slightly in some cases. Therefore, cylindrical cutting or cylindrical polishing may be performed as finishing. In order to prevent scratching, it is desired that the outer surface of the can roll 56 be subjected to treatment, such as nickel plating, diamond-like carbon coating, tungsten carbide coating, or titanium nitride coating, as required.

-Configuration Example of Gas Introduction Channel-

In this example, as illustrated in FIG. 6A, the gas introduction grooves 92 are each formed so as to have a rectangular shape (square shape) in cross-section, and are arranged at intervals $p_1$ in a circumferential direction of the inner drum 71. Therefore, the gas introduction channels 91 are arranged also at the intervals $p_1$ in the circumferential direction of the inner drum 71.

In this case, when a radius of an outer peripheral surface of the inner drum 71 other than the gas introduction grooves 92 (corresponding to a maximum diameter of a gas introduction channel cross-section) is represented by $r_1$, a radius corresponding to a deepest portion of each of the gas introduction grooves 92 (corresponding to a minimum diameter of the gas introduction channel cross-section) is represented by $r_2$, a maximum width in a circumferential direction of the gas introduction channel cross-section is represented by $w_1$, a sectional area of each of the gas introduction channels 91 is represented by $S_1$, and the number of the gas introduction channels 91 is represented by n, as illustrated in FIG. 6A and FIG. 7A, the circumferential cutoff rate A of a gas introduction channel cross-section is represented by the following expression (I).

$$\text{The circumferential cutoff rate A of a gas introduction channel cross-section} = (\text{maximum width in the circumferential direction of the gas introduction channel cross-section} \times \text{number of gas introduction channels})/(\text{length of a minimum diameter circumference m cutting across a maximum width position in the circumferential direction of the gas introduction channel cross-section) (corresponding to } 2\pi r_2 \text{ in this example})) = w_1 \times n / 2\pi r_2 \cdots (I)$$

In this example, the gas introduction channels 91 each have a rectangular shape (square shape) in cross-section. Therefore, the maximum width position in the circumferential direction is not single, and hence a reference circumference is set to the minimum diameter circumference m cutting across the maximum width position.

In addition, as illustrated in FIG. 6A and FIG. 7B, the porosity B within a gas introduction range is presented by the following expression (II).

$$\text{The porosity B within a gas introduction range} = (\text{sectional area of the gas introduction channel} \times \text{number of gas introduction channels})/(\text{annular area surrounded by a maximum diameter circumference } m_1 \text{ and a minimum diameter circumference } m_2 \text{ sandwiching the gas introduction channel cross-section}) = S_1 \times n / \pi(r_1^2 - r_2^2) \cdots (II)$$

In this example, the arrangement intervals $p_1$ of the gas introduction channels 91 and the size and sectional area of each of the gas introduction channels 91 are selected so that the circumferential cutoff rate A of a gas introduction channel cross-section is 36% or less, and the porosity B within a gas introduction range is 20% or less.

In this case, regarding the circumferential cutoff rate A of a gas introduction channel cross-section, the minimum diameter circumference m cutting across the maximum width position in the circumferential direction of the cross-section of each of the gas introduction channels 91 varies depending on the sectional shape of each of the gas introduction channels 91.

As illustrated in FIG. 8A, when the cross-section of each of the gas introduction channels 91 has a triangular shape (V-shape), the position of the maximum width $w_1$ in the circumferential direction of the cross-section of each of the gas introduction channels 91 corresponds to an outer edge of each of the gas introduction grooves 92. Therefore, the circumference cutting across the outer edge of each of the gas introduction grooves 92 corresponds to the minimum diameter circumference m.

Further, as illustrated in FIG. 8B, when the cross-section of each of the gas introduction channels 91 has a trapezoidal shape, the position of the maximum width $w_1$ in the circumferential direction of the cross-section of each of the gas introduction channels 91 corresponds to both edges of a bottom surface of each of the gas introduction grooves 92. Therefore, the circumference cutting across the both edges of the bottom surface of each of the gas introduction grooves 92 corresponds to the minimum diameter circumference m.

Further, for example, in a mode in which gas introduction channels 91' each having a circular shape in cross-section are formed on an outer cylinder portion 561 of a can roll 56' with a gun drill as in a comparative mode illustrated in FIG. 8C, the position of the maximum width $w_1$ in the circumferential direction of the cross-section of each of the gas introduction channels corresponds to a center diameter portion of each circle. Therefore, the circumference cutting across the center of each of the gas introduction channels 91' corresponds to the minimum diameter circumference m.

-Configuration Example of Gas Discharge Hole-

In addition, in this example, as illustrated in FIG. 6A and FIG. 6B, the gas discharge holes 93 are arranged at intervals $p_2$ in the circumferential direction of the can roll 56. In this example, the intervals $p_2$ are smaller than the arrangement intervals $p_1$ of the gas introduction channels 91. Specifically, $p_2=(1/2) \times p_1$.

In addition, in this example, the gas discharge holes 93 penetrate through to each of the gas introduction channels 91, and have a paired configuration (specifically 93a and 93b) in which the gas discharge holes 93 are arranged so as to be inclined symmetrically at an angle θ with respect to the radial direction of the can roll 56. The gas discharge holes 93 are arranged substantially at the intervals $p_2$ also with respect to a rotary shaft direction of the can roll 56.

In this case, the number of the gas introduction channels 91 and the number of the gas discharge holes 93 (93a and 93b) held by each of the gas introduction channels 91 can be appropriately selected in accordance with the holding angle of the long resin film 52, the tension of the long resin film 52, the discharge amount of a gas, and the like. There is no particular limitation on the diameter of each of the gas discharge holes 93 (93a and 93b) as long as a gas can be satisfactorily introduced into a gap between the can roll 56 and the long resin film 52. However, when the diameter of each of the gas discharge holes 93 exceeds 1,000 μm, the cooling efficiency in the vicinity thereof is decreased, and hence the diameter of from about 30 μm to about 1,000 μm is generally preferred. Regarding the plurality of gas discharge holes 93 formed in the respective gas introduction channels 91, it is preferred that a large number of gas discharge holes 93 each having a small diameter be arranged at small pitches from the viewpoint that the thermal conductivity can be made uniform over the entire surface of the can roll 56. However, a processing technology for forming a large number of gas discharge holes 93 each having a small diameter at small pitches involves difficulty. Therefore, in actuality, it is more preferred that the gas discharge holes 93 each having a diameter of from about 100 μm to about 500 μm be arranged at the intervals $p_2$ of from 5 mm to 10 mm.

In addition, the angle θ of the gas discharge holes 93 depends on the number of the gas introduction channels 91 because of the requirement that the intervals $p_2$ in the circumferential direction of the can roll 56 are made uniform to the extent possible. That is, when the number of the gas introduction channels 91 is large, the inclination degree of each of the gas discharge holes 93 becomes close to the radial direction of the can roll 56. When the number of the gas introduction channels 91 is small, the inclination degree thereof is increased. However, it is difficult to perform laser processing of the gas discharge holes 93 each extending in a diagonal direction. Therefore, the limit of the angle θ is 60°, and the angle θ is selected within a practical range of 40° or less.

-Relationship between Configuration of Gas Discharge Hole and Gas Pressure-

In addition, in a mode in which one gas discharge hole 93 is formed in each of the gas introduction channels 91 in the circumferential direction of the can roll 56, the arrangement intervals of the gas discharge holes 93 in the circumferential direction of the can roll 56 is excessively large, and hence there is a risk in that a gas does not permeate the entire wrapped portion between the can roll 56 and the long resin film 52.

In order to solve the above-mentioned problem, a gas pressure may be set to be high. However, when the gas pressure is increased, the long resin film 52 separates from the outer surface of the can roll 56, and there is a fear in that the cooling efficiency may be extremely decreased.

In order to prevent the foregoing, it is required to press the long resin film 52 onto the can roll 56 with a drag equal to or more than the gas pressure.

In order to obtain such a drag, it is only required that the tension of the long resin film 52 be increased. However, when the thin long resin film 52 is pulled with a high tension during a process involving applying a thermal load, there is a risk in that the long resin film 52 may be deformed. Therefore, it is required to pay attention to the tension adjustment of the long resin film 52.

For example, when a film that is as thick as 35 μm or more is targeted for deposition as the long resin film 52, there is less fear that the long resin film 52 may be deformed even when the long resin film 52 is pulled somewhat strongly.

Specifically, as the conditions under which the long resin film 52 does not separate from the can roll 56, it is only required that the following conditions be satisfied.

```
Gas Pressure (Pa) < drag F(N) = tension (N/m)/radius (m)

of can roll 56


Gas pressure (Pa) × radius (m) of can roll 56<tension (N/m)
```

-Operation of Deposition Apparatus-

According to the first embodiment, the long resin film 52 conveyed under a state of being wound around the can roll 56 is subjected to the deposition process by the magnetron sputtering cathodes 57, 58, 59, and 60 serving as deposition units.

In this case, the surface of the can roll 56 is cooled with a circulating coolant. In addition, through use of the gas rotary joint 94, a gas is discharged to a gap portion formed by the outer peripheral surface of the can roll 56 and the long resin film 52 within the holding angle range in which the long resin film 52 is brought into contact with the can roll 56, and the gas is not discharged to a region, other than the holding angle range, in which the long resin film 52 is not wound. Thus, most of the introduced gas is discharged to the gap portion formed between the outer peripheral surface of the can roll 56 and the long resin film 52. Therefore, it becomes easy to control a gas flow rate for keeping the gap interval substantially constant, and the thermal conductance in the entire gap portion between the outer peripheral surface of the can roll 56 and the long resin film 52 can be made uniform.

When the gap portion between the outer peripheral surface of the can roll 56 and the long resin film 52 is about 40 $\mu$m, the gas introduced into the can roll 56 and discharged to the gap portion can be discharged with a vacuum pump provided to the vacuum deposition apparatus. Thus, when the gas introduced into the gap portion is made the same as that in a sputtering atmosphere, the sputtering atmosphere is not contaminated. For example, argon also having relatively satisfactory thermal conduction is desired.

In particular, in the first embodiment, regarding the structure of the gas introduction channels 91 of the can roll 56, the arrangement intervals $p_1$ of the gas introduction channels 91 and the size and sectional area of each of the gas introduction channels 91 are selected so that the circumferential cutoff rate A of a gas introduction channel cross-section is 36% or less, and the porosity B within a gas introduction range is 20% or less. Therefore, the heat insulating action of the gas introduction channels 91 is not excessively strong, and the gas is discharged to the outer peripheral surface of the can roll 56 substantially uniformly, and the cooling action of the can roll 56 is efficiently achieved.

In addition, the thickness of the entire outer pipe 72 can also be reduced, and a long resin film substrate during deposition can also be efficiently cooled, with the result that the thermal conductance between the can roll 56 and the long resin film substrate can be improved, and the film temperature during treatment involving applying a thermal load, such as pretreatment and deposition, can be decreased. Therefore, through use of the processing apparatus for a long resin film substrate including the can roll 56, the occurrence of wrinkles on the long resin film substrate can be eliminated. A high-quality heat-resistant resin film with a metal film without the occurrence of wrinkles can be produced with high yield, and can be applied to a flexible wiring board of a liquid crystal television, a mobile phone, and the like.

In general, the surface of the long resin film (heat-resistant resin film) 52 and the outer peripheral surface of the can roll 56 are not perfectly flat microscopically. Therefore, in a deposition apparatus including the can roll in a related-art mode without gas discharge, a gap (gap portion) is formed between the outer peripheral surface of the can roll and the long resin film, and the thermal conduction efficiency is decreased due to heat insulation caused by a vacuum in the gap portion. As a result, the thermal conductance in the gap portion is increased, causing the occurrence of wrinkles on the heat-resistant resin film due to a thermal load during deposition or the like. For example, it has been reported that, when the introduced gas is an argon gas, in a molecular flow region in which the pressure of the introduced gas is 500 Pa and the distance of the gap portion is about 40 $\mu$m or less, the thermal conductance of the gap portion becomes 250 W/m$^2$·K (see "Improvement of Web Heat Condition by the Deposition Drum Design," 2007 Society of Vacuum Coaters, 50th. Annual Technical Conference Proceedings (2007), p.749).

The can roll 56 according to the first embodiment can be suitably used also for plasma treatment and ion beam treatment in addition to the above-mentioned deposition apparatus. Specifically, the plasma treatment and ion beam treatment are performed under a decompressed atmosphere in a vacuum chamber in order to modify the surface of the long resin film substrate. However, the plasma treatment and ion beam treatment are treatment involving applying a thermal load to the long resin film substrate, and hence the occurrence of wrinkles is caused. Therefore, when the can roll 56 according to the first embodiment is used, a gap interval between the outer peripheral surface of the can roll 56 and the long resin film substrate can be kept substantially constant, and the thermal conductance can be easily made uniform. Therefore, the occurrence of the wrinkles can be eliminated.

The plasma treatment is a method of treating a long resin film substrate through use of a known plasma treatment method, for example, by performing discharge under a decompressed atmosphere formed of a mixed gas of argon and oxygen or a mixed gas of argon and nitrogen, to thereby generate oxygen plasma or nitrogen plasma. In addition, the ion beam treatment is a method of treating a long resin film substrate through use of a known ion beam source by generating plasma discharge in a magnetic field gap having a strong magnetic field applied thereto and irradiating cations in the plasma as an ion beam through electrolysis of an anode.

In this case, as the long resin film substrate, there are given a resin film, such as a polyethylene terephthalate (PET) film, and a heat-resistant resin film, such as a polyimide film. A heat-resistant resin film with a metal film is obtained by depositing a metal film by sputtering or the like through use of a heat-resistant resin film as the long resin film substrate. Specifically, a long heat-resistant resin film with a metal film without wrinkles can be produced by a metallizing method using a deposition apparatus (sputtering web coater) for a long heat-resistant resin film with a metal film.

As the long heat-resistant resin film with a metal film, there is illustrated a structure in which a film made of a Ni-based alloy or the like and a Cu film are laminated on a surface of a heat-resistant resin film. The long heat-resistant resin film with a metal film having such a structure is processed into a flexible wiring board by a subtractive method. In this case, the subtractive method is a method involving removing a metal film (for example, the above-mentioned Cu film) that is not covered with a resist by etching to manufacture a flexible wiring board.

The above-mentioned film made of a Ni-based alloy or the like is called a seed layer, and a Ni-Cr alloy or various known alloys, such as Inconel, Constantan, and Monel, may be used. The composition thereof is selected in accordance with the desired characteristics, such as an electrical insulating property and migration resistance, of the long heat-resistant resin film with a metal film. In addition, when the thickness of the metal film of the long heat-resistant resin film with a metal film is to be further increased, the metal film may be formed through use of a wet plating method in some cases. There are also a case in which the metal film is formed only by electroplating and a case in which the metal film is formed through combination of electroless plating as primary plating and the wet plating method, such as electrolytic plating as secondary plating. In the wet plating, it is only required that various conditions of an ordinary wet plating method be adopted.

Further, examples of heat-resistant resin films which may be used in the long heat-resistant resin film with a metal film include a polyimide-based film, a polyamide-based film, a polyester-based film, a polytetrafluoroethylene-based film, a polyphenylene sulfide-based film, a polyethylene naphthalate-based film, and a liquid-crystal polymer-based film. Those heat-resistant resin films are preferred from the viewpoint of having flexibility and practically required strength as a flexible substrate with a metal film and a suitable electrical insulating property as a wiring material.

As the above-mentioned heat-resistant resin film with a metal film, there is illustrated a structure in which metal films of a Ni-Cr alloy, Cu, and the like are laminated on a long heat-resistant resin film. However, an oxide film, a nitride film, a carbide film, and the like may also be used in accordance with the purpose in addition to the above-mentioned metal films. Also in this case, the can roll 56, the deposition apparatus, and the deposition method according to the first embodiment can be used for deposition of an oxide film, a nitride film, a carbide film, and the like.

Examples

As Comparative Examples 1 and 2 and Examples 1 to 4, can rolls respectively having gas discharge hole shapes of FIG. 9A to FIG. 9F were produced.

Comparative Example 1

In Comparative Example 1, as illustrated in FIG. 9A, the gas introduction channels 91' each having a circular shape in cross-section are formed at predetermined intervals in a circumferential direction in the outer cylinder portion 561 of the can roll 56'. Further, gas discharge holes 93' that penetrate through to the gas introduction channels 91' are arranged so as to be inclined with respect to a radial direction of the can roll 56' and are arranged at substantially the same intervals as those of the gas introduction channels 91'.

Comparative Example 2

In Comparative Example 2, as illustrated in FIG. 9B, the gas introduction channels 91' each having a circular shape in cross-section are formed with a gun drill at predetermined intervals in the circumferential direction in the outer cylinder portion 561 of the can roll 56'. Further, the gas discharge holes 93' that penetrate through to the gas introduction channels 91' are arranged so as to be inclined symmetrically with respect to the radial direction of the can roll 56', and are arranged at intervals that are substantially a half of the arrangement intervals of the gas introduction channels 91'.

Example 1

In Example 1, as illustrated in FIG. 9C, a part of the can roll 56 according to the first embodiment is changed. The gas introduction channels 91 each having a rectangular shape (square in this example) in cross-section are arranged at predetermined intervals. Further, the gas discharge holes 93 that penetrate through to the gas introduction channels 91 are arranged so as to be inclined with respect to the radial direction of the can roll 56, and are arranged at substantially the same intervals as those of the gas introduction channels 91.

Example 2

In Example 2, as illustrated in FIG. 9D, the can roll 56 according to the first embodiment is achieved. The gas introduction channels 91 each having a rectangular shape (square in this example) in cross-section are arranged at predetermined intervals. Further, the gas discharge holes 93 that penetrate through to the gas introduction channels 91 are arranged so as to be inclined symmetrically with respect to the radial direction of the can roll 56, and are arranged at intervals that are substantially a half of the arrangement intervals of the gas introduction channels 91.

Example 3

In Example 3, as illustrated in FIG. 9E, a part of the can roll 56 according to the first embodiment is changed. The gas introduction channels 91 each having a rectangular shape (triangular shape in this example) in cross-section are arranged at predetermined intervals. Further, the gas discharge holes 93 that penetrate through to the gas introduction channels 91 are arranged so as to be inclined with respect to the radial direction of the can roll 56, and are arranged at substantially the same intervals as those of the gas introduction channels 91.

Example 4

In Example 4, as illustrated in FIG. 9F, the can roll 56 according to the first embodiment is achieved. The gas introduction channels 91 each having a rectangular shape (triangular shape in this example) in cross-section are arranged at predetermined intervals. Further, the gas discharge holes 93 that penetrate through to the gas introduction channels 91 are arranged so as to be inclined symmetrically with respect to the radial direction of the can roll 56, and are arranged at intervals that are substantially a half of the arrangement intervals of the gas introduction channels 91.

Here, in FIG. 11, FIG. 12, and FIG. 13, the sectional shape of each of the gas introduction channels 91 (91') is a circular shape formed with a gun drill in Comparative Examples 1 and 2, and a square shape and a triangular shape formed on the outer surface of the inner drum 71 by grooving in Examples 1 to 4. In a precise sense, an inner wall of the outer pipe 72 to be shrink-fitted is not a straight line but an arc. However, a sectional area of each introduction channel was calculated assuming that the inner wall of the outer pipe 72 was a straight line. The square shape was regarded as a square, and the apex angle of the triangular shape was set to 60°. In addition, the outer diameter of the can roll 56 (56') (outer diameter of the outer pipe 72) was set to 800 mm. The thickness of the outer pipe 72 was set to 2 mm in the case of Examples 1 to 4, and the minimum distance from each of the gas introduction channels 91' to the outer diameter of the can roll 56' was set to 2 mm in the case of the gun drill in Comparative Examples 1 and 2 (see FIG. 10). In addition, when each pitch of the arrangement intervals is 1°, the number of the gas introduction channels 91 (91') is 360. When each pitch is 2°, the number of the gas introduction channels 91 (91') is 180. When each pitch is 3°, the number of the gas introduction channels 91 (91') is 120. The area sectional area refers to a sectional area of an annular area (corresponding to an area between the inner diameter of the outer pipe and the radius of the deepest portion of the gas introduction channel in Examples 1 to 4) in which the gas introduction channel 91 (91') is formed. In addition, the porosity is a total sectional area/area sectional area of the gas introduction channel 91 (91').

In FIG. 10A, examples of Comparative Examples 1 and 2 are illustrated. In FIG. 10B, FIG. 10E, and FIG. 10G, examples of Examples 1 and 2 are illustrated. In FIG. 10D, FIG. 10F, and FIG. 10H, examples of Examples 3 and 4 are illustrated. In FIG. 10C, modification examples of Examples 1 and 2 are illustrated.

In addition, the maximum cutoff length refers to a maximum width of one gas introduction channel. The circumference of the maximum cutoff length refers to a circumference of a radius in which the maximum cutoff length of the gas introduction channel is positioned. The circumferential cutoff rate refers to a maximum cutoff length/circumference of a maximum cutoff length.

In a construction method using the gun drill in Comparative Examples 1 and 2, the gun drill diameter that can be formed from both ends in an outer peripheral portion of the can roll 56' having a diameter of 800 mm is at most 5 mm. In the case of a gun drill diameter of 3 mm and 4 mm, it is extremely difficult to match opening positions in a center portion when holes are formed from both ends. In addition, in a mode in which two gas discharge holes were formed under a state of being inclined from the radial direction with respect to each of the gas introduction channels 91', when each pitch of the gas introduction channels 91' was 3°, the inclination angle of each of the gas discharge holes 93' deviated significantly from the radial direction when an attempt was made to keep the gas discharge hole pitches in the circumferential direction uniform. Accordingly, the opening distance became long, with the result that the gas discharge holes were not able to penetrate through with a laser drill.

In addition, in a construction method using grooving and shrink-fitting in Examples 1 to 4, the cross-section of the gas introduction channel 91 can be formed into any of a square shape and a triangular shape, each having a side length of 3 mm, 4 mm, or 5 mm. In addition, in a mode in which two gas discharge holes 93 were formed under a state of being inclined from the radial direction with respect to the gas introduction channel 91, when each pitch of the gas introduction channels 91 was 3°, the inclination angle of each of the gas discharge holes 93 deviated significantly from the radial direction when an attempt was made to keep the gas discharge hole pitches in the circumferential direction uniform. Accordingly, the opening distance became long, with the result that the gas discharge holes were not able to penetrate through with a laser drill.

Thus, the can roll 56 that can be actually manufactured is combinations without "-" in overall evaluation in FIG. 11, FIG. 12, and FIG. 13.

Then, the can roll 56 in which stainless steel was used for the inner drum 71 and the outer pipe 72 was produced, and deposition was performed through use of the deposition apparatus (sputtering web coater) for a long heat-resistant resin film with a metal film illustrated in FIG. 2. In this example, the can roll 56 had a diameter of 800 mm. A Ni-Cr alloy serving as a seed layer was deposited to a thickness of 50 nm (through use of one target) on a long resin film substrate, and a Cu film was deposited thereon to a thickness of 150 nm (through use of three targets). The film conveyance speed was 8 m/min. The introduction power to each cathode was about 30 kW, and a total of the introduction power was 120 kW. As the long resin film substrate, a heat-resistant polyimide film "Kapton (trademark)" manufactured by Du Pont-Toray Co., Ltd. having a width of 500 mm, a length of 1,500 m, and a thickness of 25 $\mu$m, which was separately dried in vacuum, was used. The pressure in the gap portion between the surface of the can roll 56 and the long resin film 52 was set to 800 Pa through pressure control of an argon gas.

In a mode in which one gas discharge hole 93 was formed under a state of being inclined from the radial direction with respect to each of the gas introduction channels 91, in a case in which each pitch of the gas introduction channels 91 was any of 2° and 3°, and each of the gas discharge hole pitches in the circumferential direction was more than 12 mm, the gas pressure was not stabilized when the long resin film conveyance length reached a high speed. In addition, in the case of the porosity B of more than 20%, and the case of the circumferential cutoff rate A of more than 36%, slight wrinkles or deformation occurred in the films during deposition. Consequently, satisfactory cooling performance was exhibited to a thermal load of sputtering only in the case in which each pitch was 2° among the modes in which the two gas discharge holes 93 penetrated through to the cross-section of each of the gas introduction channels 91 in Example 4 in overall evaluation of FIG. 11, FIG. 12, and FIG. 13.

In this example, the following result was obtained. That is, the performance evaluation is satisfactory in Example 4 (mode in which the sectional shape of each of the gas introduction channels 91 is a triangular shape) as compared to Example 2 (mode in which the sectional shape of each of the gas introduction channels 91 is a square shape). The reason for this is considered as follows. The sectional area of the gas introduction channel 91 is smaller in Example 4 than in Example 2, and hence the heat insulating action of the gas introduction channel 91 is small.

In particular, when the sectional shape of the gas introduction channel 91 is a triangular shape (V-shape), it is preferred that the apex angle of the gas introduction channel 91 be twice or more the inclination angle $\theta$ of the gas discharge hole 93. The reason for this is, for example, that the gas discharge resistance from the gas introduction channel 91 to the gas discharge hole 93 is small.

In addition, in Example 2, when the cooling performance was evaluated in a mode in which the sectional shape of each of the gas introduction channels 91 was a square shape (square in Example), the porosity B within a gas introduction range was more than 20% in any mode. Therefore, "o" was not obtained as overall evaluation in FIG. 11, FIG. 12, and FIG. 13. However, for example, as illustrated in FIG. 10C, when the sectional shape of the gas introduction channel 91 was set to a rectangle narrower than a square, and the porosity B within a gas introduction range was set so as to become 20% or less in any long side of from 3 mm to 5 mm in the case of a pitch of 2°, it was confirmed that overall evaluation became satisfactory.

In addition, as described in Examples 1 and 3, in a mode in which one gas discharge hole 93 was formed in the circumferential direction of the can roll 56 with respect to each of the gas introduction channels 91, the deposition process was performed under the condition that the long resin film 52 did not separate from the outer surface of the can roll 56.

In this case, it is only required that the tension of the long resin film 52 be set to be higher than the gas pressure of 800 (Pa) $\times$ can roll radius of 0.4 m = 320 (N/m). Thus, the tension is required to be set to be higher than 320 N for the long resin film width of 1 m, and it is only required that the tension be set to be higher than 160 N when the long resin film width is 0.5 m.

As a result of the deposition process under the above-mentioned condition, the following was confirmed. In the case of a pitch of 2°, for example, in a mode in which the sectional shape of each of the gas introduction channels 91 is a triangular shape, when the circumferential cutoff rate A of a gas introduction channel cross-section is 36% or less or when the porosity B within a gas introduction range is 20% or less, wrinkles do not occur in the long resin film 52, and the cooling performance is satisfactory.

Thus, according to at least one embodiment of the present invention, the can roll, which is configured to subject a film to a deposition process in vacuum as in a sputtering web coater, can also efficiently cool a long resin film substrate during deposition, with the result that the thermal conductance between the can roll and the long resin film substrate is improved, and the film temperature can be decreased during treatment involving applying a thermal load, such as pretreatment and deposition. Therefore, with a processing apparatus for a long resin film substrate including the can roll and a processing method, the occurrence of wrinkles of the long resin film substrate can be eliminated. Then, a high-quality heat-resistant resin film with a metal film without the occurrence of wrinkles can be produced with high yield, and can be applied to a flexible wiring board of a liquid crystal television, a mobile phone, and the like.

REFERENCE SIGNS LIST

1 gas discharge roll
2 inner roll
3 outer roll
4 gas introduction groove
5 gas introduction channel
6 gas discharge hole
7 coolant partition member
8 coolant circulation channel
11 long resin film
12 conveyance unit
13 surface treatment unit
A circumferential cutoff rate of a gas introduction channel cross-section
B porosity within a gas introduction range
r1 radius of an outer peripheral surface of the inner drum other than the gas introduction grooves
r2 radius corresponding to a deepest portion of each of the gas introduction grooves
50 deposition apparatus
51 unwinding roll
52 long resin film
53 free roll
54 tension sensor roll
55 feed roll
56 can roll
57 magnetron sputtering cathode
58 magnetron sputtering cathode
59 magnetron sputtering cathode
60 magnetron sputtering cathode
61 feed roll
62 tension sensor roll
63 free roll
64 winding roll
71 inner drum
71a rotary shaft
72 outer pipe
73 bearings
74 welding
75 side plates
80 coolant circulation channel
81 coolant circulation pipe
90 gas introduction/discharge mechanism
91,91' gas introduction channels
92 gas introduction grooves

93(93a,93b),93' gas discharge holes
94 gas rotary joint
95 gas introduction port
$P_1$ arrangement intervals of the gas introduction channels
$P_2$ arrangement intervals of the gas discharge holes
m minimum diameter circumference cutting across the maximum width position.
$m_1$ maximum diameter circumference sandwiching the gas introduction channel cross-section
$m_2$ minimum diameter circumference sandwiching the gas introduction channel cross-section
$w_1$ maximum width in a circumferential direction of the gas introduction channel cross-section
$S_1$ sectional area of each of the gas introduction channels
n number of the gas introduction channels

**Claims**

**1.** A gas discharge roll, comprising:

an inner roll, which is made of metal, and has a rotary shaft in an end portion;
an outer roll, which is made of metal with a cylindrical shape, and is fitted and integrated with an outer peripheral surface of the inner roll;
gas introduction grooves, which are formed on the outer peripheral surface of the inner roll over an entire circumference thereof at substantially uniform intervals along a circumferential direction of the inner roll so as to extend along a rotary shaft direction of the inner roll, and which define gas introduction channels between an inner peripheral surface of the outer roll and the gas introduction grooves; and
a group of gas discharge holes formed on the outer roll so as to penetrate through to the gas introduction channels, wherein the gas discharge roll has a circumferential cutoff rate A of a gas introduction channel cross-section of 36% or less,

where the circumferential cutoff rate A of a gas introduction channel cross-section = (maximum width in the circumferential direction of the gas introduction channel cross-section × number of gas introduction channels)/(minimum diameter circumference length cutting across a maximum width position in the circumferential direction of the gas introduction channel cross-section).

**2.** A gas discharge roll, comprising:

an inner roll, which is made of metal, and has a rotary shaft in an end portion;
an outer roll, which is made of metal with a cylindrical shape, and is fitted and integrated with an outer peripheral surface of the inner roll;
gas introduction grooves, which are formed on the outer peripheral surface of the inner roll over an entire circumference thereof at substantially uniform intervals along a circumferential direction of the inner roll so as to extend along a rotary shaft direction of the inner roll, and which define gas introduction channels between an inner peripheral surface of the outer roll and the gas introduction grooves; and
a group of gas discharge holes formed on the outer roll so as to penetrate through to the gas introduction channels, wherein the gas discharge roll has a porosity B within a gas introduction range of 20% or less,

where the porosity B within a gas introduction range = (sectional area of the gas introduction channel × number of gas introduction channels)/(annular area surrounded by a maximum diameter circumference and a minimum diameter circumference sandwiching the gas introduction channel cross-section).

3. The gas discharge roll according to claim 1 or 2, wherein the group of gas discharge holes have arrangement intervals along the circumferential direction of the gas discharge roll, which are smaller than arrangement intervals of the gas introduction channels.

4. The gas discharge roll according to claim 1 or 2, wherein the gas introduction grooves each have a non-circular cross-section.

5. The gas discharge roll according to claim 1 or 2, wherein the group of gas discharge holes are each arranged so as to be inclined with respect to a radial direction of the outer roll.

6. A method of manufacturing a gas discharge roll, the gas discharge roll including an inner roll, which is made of metal and has a rotary shaft in an end portion, and an outer roll, which is made of metal with a cylindrical shape and has an inner peripheral surface that is brought into contact with an outer peripheral surface of the inner roll, the gas discharge roll enabling a gas to be discharged to a surface of the outer roll,
the method comprising:

a groove forming step of forming a plurality of gas introduction grooves each extending in a rotary shaft direction on the outer peripheral surface of the inner roll over an entire circumference thereof at substantially uniform intervals;
a shrink fitting step of shrink-fitting the outer roll with the outer peripheral surface of the inner roll having the plurality of gas introduction grooves formed thereon in the groove forming step;
a joining step of joining the inner roll and the outer roll, which have been shrink-fitted with each other, by welding; and
a hole forming step of forming a group of gas discharge holes on the outer roll, the group of gas discharge holes respectively penetrating through to a plurality of gas introduction channels defined between the plurality of gas introduction grooves formed on the outer peripheral surface of the inner roll and the inner peripheral surface of the outer roll,
wherein the groove forming step is performed so that the gas discharge roll has a circumferential cutoff rate A of a gas introduction channel cross-section of 36% or less,

where the circumferential cutoff rate A of a gas introduction channel cross-section = (maximum width in the circumferential direction of the gas introduction channel cross-section × number of gas introduction channels)/(minimum diameter circumference length cutting across a maximum width position in the circumferential direction of the gas introduction channel cross-section).

7. A method of manufacturing a gas discharge roll, the gas discharge roll including an inner roll, which is made of metal and has a rotary shaft in an end portion, and an outer roll, which is made of metal with a cylindrical shape and has an inner peripheral surface that is brought into contact with an outer peripheral surface of the inner roll, the gas discharge roll enabling a gas to be discharged to a surface of the outer roll,
the method comprising:

a groove forming step of forming a plurality of gas introduction grooves each extending in a rotary shaft direction on the outer peripheral surface of the inner roll over an entire circumference thereof at substantially uniform intervals;
a shrink fitting step of shrink-fitting the outer roll with the outer peripheral surface of the inner roll having the plurality of gas introduction grooves formed thereon in the groove forming step;
a joining step of joining the inner roll and the outer roll, which have been shrink-fitted with each other, by welding; and
a hole forming step of forming a group of gas discharge holes on the outer roll, the group of gas discharge holes respectively penetrating through to a plurality of gas introduction channels defined between the plurality of gas introduction grooves formed on the outer peripheral surface of the inner roll and the inner peripheral surface of the outer roll,
wherein the groove forming step is performed so that the gas discharge roll has a porosity B within a gas introduction range of 20% or less,

```
where the porosity B within a gas introduction range =
(sectional area of the gas introduction channel × number of gas
introduction channels)/(annular area surrounded by a maximum
diameter circumference and a minimum diameter circumference
sandwiching the gas introduction channel cross-section).
```

8. A processing apparatus, comprising:

the gas discharge roll of any one of claims 1 to 5;
a conveyance unit conveyed a long resin film while winding the long resin film around the gas discharge roll; and
a surface treatment unit, which is provided so as to be opposed to an outer peripheral surface of the gas discharge roll, and which performs surface treatment involving applying a thermal load onto the long resin film wound around the gas discharge roll.

1 GAS DISCHARGE ROLL

FIG.1A

12 CONVEYANCE UNIT

11 LONG RESIN FILM

13 SURFACE TREATMENT UNIT

FIG.1B

3 OUTER ROLL

5 GAS INTRODUCTION
CHANNEL

6 GAS DISCHARGE
HOLE

6

4 GAS INTRODUCTION
GROOVE

2 INNER ROLL

8 COOLANT CIRCULATION
CHANNEL

7 COOLANT PARTITION
MEMBER

FIG.1C

5   6      A      6   3

2      B     4   r2   r1

24

# FIG.2

# FIG.3

EP 3 798 331 A1

# FIG.4

| 92 | 72 | 74 | | |
|---|---|---|---|---|
| INNER DRUM GROOVING | OUTER PIPE SHRINK FITTING | LASER WELDING | OUTER PIPE GRINDING | HARD CHROMIUM PLATING |

| | 93 | 75   93 | 93   56 |
|---|---|---|---|
| POLISHING | LASER HOLE FORMING | SIDE PLATE LASER WELDING | POLISHING |

EP 3 798 331 A1

FIG.5A

FIG.5B

FIG.5C

FIG.5D

FIG.5E

## FIG.6A

## FIG.6B

# FIG.7A

# FIG.7B

# FIG.8A

93b (93)  w1  93a (93)  56

w1          w1          m

72
71
91    92

r2                          r1

80

# FIG.8B

93b (93)  w1  93a (93)  56

w1          w1          m

72
71
91    92

r2                          r1

80

# FIG.8C

91'  93'                56'

m  561

w1

FIG.9A  FIG.9B  FIG.9C  FIG.9D  FIG.9E  FIG.9F

FIG.10A

2° PITCH

91'

40

5 Φ

4.5

FIG.10B

2°
PITCH

91

5 × 5

2

FIG.10C

91

5 × 3

2

FIG.10D

91

5

60°

2

FIG.10E

91

3 × 3

2

FIG.10F

91

4

60°

2

FIG.10G

91

3 × 3

1° PITCH

2

FIG.10H

91

4

60°

2

# FIG.11

| SHAPE | DIAME-TER (mm) | PITCH (°) | SECTIONAL AREA /CHANNEL (mm²) | SECTIONAL AREA (mm²) | AREA SECTIONAL AREA (mm²) | POROSITY B (%) | MAXIMUM CUTOFF LENGTH /CHANNEL (mm) | MAXIMUM CUTOFF LENGTH (mm) |
|---|---|---|---|---|---|---|---|---|
| CIRCULAR SHAPE | 3.0 | 1 | 7.1 | 2545 | 7474 | 34 | 3.0 | 1080 |
| | | 2 | | 1272 | | 17 | | 540 |
| | | 3 | | 848 | | 11 | | 360 |
| | 4.0 | 1 | 12.6 | 4524 | 9953 | 45 | 4.0 | 1440 |
| | | 2 | | 2262 | | 23 | | 720 |
| | | 3 | | 1508 | | 15 | | 480 |
| | 5.0 | 1 | 19.6 | 7069 | 12425 | 57 | 5.0 | 1800 |
| | | 2 | | 3534 | | 28 | | 900 |
| | | 3 | | 2356 | | 19 | | 600 |

| SHAPE | H (mm) | CIRCUMFERENTIAL CUTOFF RATE A (%) | GUN DRILL | HOLE PITCH IN CIRCUMFERENTIAL DIRECTION J (mm) | STABILITY BY LASER DIAGONAL GAS DISCHARGE HOLE PITCH (J) |
|---|---|---|---|---|---|
| CIRCULAR SHAPE | 2491 | 43 | × | 7.0 | ○ |
| | | 22 | × | 14.0 | × |
| | | 14 | × | 20.9 | × |
| | 2488 | 58 | × | 7.0 | ○ |
| | | 29 | × | 14.0 | × |
| | | 19 | × | 20.9 | × |
| | 2485 | 72 | ○ | 7.0 | ○ |
| | | 36 | ○ | 14.0 | × |
| | | 24 | ○ | 20.9 | × |

| SHAPE | OVERALL EVALUATION (J) | HOLE PITCH IN CIRCUMFERENTIAL DIRECTION K (mm) | DIAGONAL HOLE PENETRATION (K) | OVERALL EVALUATION (K) |
|---|---|---|---|---|
| CIRCULAR SHAPE | — | 3.5 | ○ | — |
| | — | 7.0 | ○ | — |
| | — | 10.5 | × | — |
| | — | 3.5 | ○ | — |
| | — | 7.0 | ○ | — |
| | — | 10.5 | × | — |
| | × | 3.5 | ○ | × |
| | × | 7.0 | ○ | × |
| | × | 10.5 | × | — |

# FIG.12

| SHAPE | SIDE LENGTH (mm) | PITCH (°) | SECTIONAL AREA /PIECE (mm²) | SECTIONAL AREA (mm²) | AREA SECTIONAL AREA (mm²) | POROSITY B (%) | CUTOFF LENGTH /PIECE (mm) | MAXIMUM CUTOFF LENGTH (mm) |
|---|---|---|---|---|---|---|---|---|
| SQUARE SHAPE | 3.0 | 1 | 9.0 | 3240 | 7474 | 43 | 3.0 | 1080 |
|  |  | 2 |  | 1620 |  | 22 |  | 540 |
|  |  | 3 |  | 1080 |  | 14 |  | 360 |
|  | 4.0 | 1 | 16.0 | 5760 | 9953 | 58 | 4.0 | 1440 |
|  |  | 2 |  | 2880 |  | 29 |  | 720 |
|  |  | 3 |  | 1920 |  | 19 |  | 480 |
|  | 5.0 | 1 | 25.0 | 9000 | 12425 | 72 | 5.0 | 1800 |
|  |  | 2 |  | 4500 |  | 36 |  | 900 |
|  |  | 3 |  | 3000 |  | 24 |  | 600 |

| SHAPE | H (mm) | CIRCUMFERENTIAL CUTOFF RATE A (%) | GROOVING | HOLE PITCH IN CIRCUMFERENTIAL DIRECTION J (mm) | STABILITY BY LASER DIAGONAL GAS DISCHARGE HOLE PITCH (J) |
|---|---|---|---|---|---|
| SQUARE SHAPE | 2482 | 44 | ○ | 7.0 | ○ |
|  |  | 22 | ○ | 14.0 | × |
|  |  | 15 | ○ | 20.9 | × |
|  | 2476 | 58 | ○ | 7.0 | ○ |
|  |  | 29 | ○ | 14.0 | × |
|  |  | 19 | ○ | 20.9 | × |
|  | 2469 | 73 | ○ | 7.0 | ○ |
|  |  | 36 | ○ | 14.0 | × |
|  |  | 24 | ○ | 20.9 | × |

| SHAPE | OVERALL EVALUATION (J) | HOLE PITCH IN CIRCUMFERENTIAL DIRECTION K (mm) | LASER DIAGONAL HOLE (K) | OVERALL EVALUATION (K) |
|---|---|---|---|---|
| SQUARE SHAPE | × | 3.5 | ○ | × |
|  | × | 7.0 | ○ | × |
|  | × | 10.5 | × | — |
|  | × | 3.5 | ○ | × |
|  | × | 7.0 | ○ | × |
|  | × | 10.5 | × | — |
|  | × | 3.5 | ○ | × |
|  | × | 7.0 | ○ | × |
|  | × | 10.5 | × | — |

# FIG.13

| SHAPE | BOTTOM SIDE LENGTH (mm) | PITCH (°) | SECTIONAL AREA /PIECE (mm²) | SECTIONAL AREA (mm²) | AREA SECTIONAL AREA (mm²) | POROSITY B (%) | CUTOFF LENGTH /PIECE (mm) | MAXIMUM CUTOFF LENGTH (mm) |
|---|---|---|---|---|---|---|---|---|
| APEX ANGLEOF TRIAN-GULAR SHAPE IS 60° | 3.0 | 1 | 3.9 | 1403 | 6476 | 22 | 3.0 | 1080 |
| | | 2 | | 701 | | 11 | | 540 |
| | | 3 | | 468 | | 7 | | 360 |
| | 4.0 | 1 | 6.9 | 2494 | 8625 | 29 | 4.0 | 1440 |
| | | 2 | | 1247 | | 14 | | 720 |
| | | 3 | | 831 | | 10 | | 480 |
| | 5.0 | 1 | 10.8 | 3897 | 10769 | 36 | 5.0 | 1800 |
| | | 2 | | 1949 | | 18 | | 900 |
| | | 3 | | 1299 | | 12 | | 600 |

| SHAPE | H (mm) | CIRCUMFERENTIAL CUTOFF RATE A (%) | GROOVING | HOLE PITCH IN CIRCUMFERENTIAL DIRECTION J (mm) | STABILITY BY LASER DIAGONAL GAS DISCHARGE HOLE PITCH (J) |
|---|---|---|---|---|---|
| APEX ANGLEOF TRIAN-GULAR SHAPE IS 60° | 2482 | 44 | O | 7.0 | O |
| | | 22 | O | 14.0 | × |
| | | 15 | O | 20.9 | × |
| | 2476 | 58 | O | 7.0 | O |
| | | 29 | O | 14.0 | × |
| | | 19 | O | 20.9 | × |
| | 2469 | 73 | O | 7.0 | O |
| | | 36 | O | 14.0 | × |
| | | 24 | O | 20.9 | × |

| SHAPE | OVERALL EVALUATION (J) | HOLE PITCH IN CIRCUMFERENTIAL DIRECTION K (mm) | LASER DIAGONAL HOLE (K) | OVERALL EVALUATION (K) |
|---|---|---|---|---|
| APEX ANGLEOF TRIAN-GULAR SHAPE IS 60° | × | 3.5 | O | × |
| | × | 7.0 | O | O |
| | × | 10.5 | × | — |
| | × | 3.5 | O | × |
| | × | 7.0 | O | O |
| | × | 10.5 | × | — |
| | × | 3.5 | O | × |
| | × | 7.0 | O | O |
| | × | 10.5 | × | — |

**INTERNATIONAL SEARCH REPORT**

| International application No. |
| --- |
| PCT/JP2019/002301 |

A. CLASSIFICATION OF SUBJECT MATTER
Int.Cl. C23C14/56(2006.01)i, F16C13/00(2006.01)i

According to International Patent Classification (IPC) or to both national classification and IPC

B. FIELDS SEARCHED

Minimum documentation searched (classification system followed by classification symbols)
Int.Cl. C23C14/56, F16C13/00

Documentation searched other than minimum documentation to the extent that such documents are included in the fields searched
Published examined utility model applications of Japan 1922–1996
Published unexamined utility model applications of Japan 1971–2019
Registered utility model specifications of Japan 1996–2019
Published registered utility model applications of Japan 1994–2019

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y<br>A | JP 2017-110239 A (SUMITOMO METAL MINING CO., LTD.)<br>22 June 2017, paragraphs [0027], [0053], [0057]–<br>[0059], [0065]–[0068], fig. 1, 3, 4, 7–9<br>(Family: none) | 1, 3–5, 8<br>3–6, 8<br>2, 7 |
| X<br>Y<br>A | JP 2014-234541 A (SUMITOMO METAL MINING CO., LTD.)<br>15 December 2014, paragraphs [0070], [0074]–<br>[0077], fig. 3, 4, 7<br>(Family: none) | 1, 4, 6, 8<br>3–6, 8<br>2, 7 |

☒ Further documents are listed in the continuation of Box C.　　　☐ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>08.04.2019 | Date of mailing of the international search report<br>23.04.2019 |
| --- | --- |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**EP 3 798 331 A1**

## INTERNATIONAL SEARCH REPORT

International application No.

PCT/JP2019/002301

C (Continuation). DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2013-7073 A (SUMITOMO METAL MINING CO., LTD.)<br>10 January 2013, paragraphs [0054], [0071]-[0073],<br>fig. 3, 5<br>(Family: none) | 1, 4, 8<br>3-6, 8<br>2, 7 |

Form PCT/ISA/210 (continuation of second sheet) (January 2015)

38

## REFERENCES CITED IN THE DESCRIPTION

### Patent documents cited in the description

- JP HEI2098994 B
- JP 3447070 B
- JP 62247073 A
- WO 2005001157 A
- JP 5920199 B
- JP 5970422 B
- JP 5673610 B
- JP SHO62247073 B

### Non-patent literature cited in the description

- Vacuum Heat Transfer Models for Web Substrates: Review of Theory and Experimental Heat Transfer Data. 43rd. Annual Technical Conference Proceedings-Denver. Society of Vacuum Coaters, 335
- Improvement of Web Heat Condition by the Deposition Drum Design. 50th. Annual Technical Conference Proceedings. Society of Vacuum Coaters, 2007, 749
- Vacuum Heat Transfer Models for Web Substrates: Review of Theory and Experimental Heat Transfer Data. 43rd Annual Technical Conference Proceeding. Society of Vacuum Coaters, 15 April 2000, 335
- Improvement of Web Condition by the Deposition Drum Design. 50th Annual Technical Conference Proceeding. Society of Vacuum Coaters, 2007, 749